(19) **Europäisches Patentamt European Patent Office Office européen des brevets**

(11) **EP 4 660 884 A1**

(12) **EUROPEAN PATENT APPLICATION**
published in accordance with Art. 153(4) EPC

(43) Date of publication:
**10.12.2025 Bulletin 2025/50**

(51) International Patent Classification (IPC):
*G06N 3/063* (2023.01)  *G06N 3/08* (2023.01)
*H01L 27/06* (2006.01)

(21) Application number: 24792785.8

(22) Date of filing: **22.01.2024**

(86) International application number:
**PCT/KR2024/001021**

(87) International publication number:
**WO 2024/219597 (24.10.2024 Gazette 2024/43)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **18.04.2023 KR 20230050478**

(71) Applicant: **Seoul National University R&DB Foundation**
**Seoul 08826 (KR)**

(72) Inventors:
• **KIM, Sangbum**
  **Seoul 08826 (KR)**
• **KANG, Jaehyeon**
  **Seoul 08786 (KR)**

(74) Representative: **Isarpatent**
**Patent- und Rechtsanwälte**
**Barth Hassa Peckmann & Partner mbB**
**Friedrichstraße 31**
**80801 München (DE)**

(54) **CHARGE STORING TYPE SYNAPSE DEVICE FOR DEEP NEURAL NETWORK TRAINING AND METHOD FOR DRIVING SAME**

(57)     A charge-storing synapse device for deep neural network training and a driving method thereof are disclosed. The disclosed synapse device may include a weight capacitor having a first terminal and a second terminal and storing voltage corresponding to the weight; four control transistors which change a voltage or a weight of the capacitor; a first output transistor including a first gate terminal coupled to the first terminal of the capacitor, and outputting a first drain current according to a voltage applied to the first gate terminal; and a second output transistor including a second gate terminal coupled to the second terminal of the capacitor, and outputting a second drain current according to the voltage applied to the second gate terminal, and wherein the weight may be determined by the difference between the first drain current and the second drain current.

*FIG. 1B*

EP 4 660 884 A1

**Description**

**BACKGROUND OF THE INVENTION**

**TECHNICAL FIELD**

The present invention relates to a synapse device and a driving method thereof, and more particularly, to a synapse device of a charge storage type for deep neural network training and a driving method thereof.

**BACKGROUND ART**

Recently, with the development of industries utilizing artificial intelligence based on artificial neural networks, computing structures optimized for artificial neural network operations have been widely proposed. In particular, it is known that low-power and high-efficiency deep neural network computing may be realized through a hardware structure which may maximize the efficiency of large-scale parallel multiply-and-accumulation (MAC) operations. In connection with this structure, an analog RPU (Resistive Processing Unit) architecture with a crossbar array structure has been proposed and is known. The unit cell of the RPU architecture may adjust the artificial neural network synapse weight connection intensity by changing electrical conductivity or stored charge amount according to the input pulse signal. This allows the artificial neural network synapse to perform multiplication, accumulation operations and weight storage simultaneously.

Additionally, artificial neural network synapses have different requirements for learning and inference operations. For devices for learning, computational accuracy is more important than non-volatility. On the other hand, for inference devices, it is more important to preserve the learned weights well. Changes in device requirements according to the relationship with the performance of these computational functions appear similarly in memory devices of the von Neumann-based computing system which is currently widely used. In addition to SRAM, which is used as the element closest to the computing device, DRAM, which takes programs from auxiliary memory and uses them as main memory is volatile, but is characterized by high speed and wide bandwidth. On the other hand, for auxiliary storage devices, it is important to properly preserve data for which calculations have been completed, and it is important to store large amounts of data. Likewise, current memory devices also have a hierarchical structure with different requirements to interact with computing devices.

Meanwhile, the number of devices connected to the next-generation IoT network is expected to increase remarkably from 8 billion in 2017 to 70 billion in 2025, but mobile devices and IoT devices lack deep neural network computing capabilities and rely on cloud or data server computing. In a hyper-connected information and communication society, there is a need to dramatically reduce power consumption requirements for data computation and communication. In the era of the 4th Industrial Revolution represented by hyper-connectivity based on IoT and big data technology, a new concept of computing technology which minimizes power consumption and is innovatively differentiated from existing methods is required. The brain nerve simulation calculation method which receives massive amounts of unstructured data and has high energy efficiency like the human brain, is a next-generation computing solution needed for artificial intelligence, big data, sensor networks, and pattern/object recognition.

Research on cranial nerve simulation computing devices to date has focused on securing symmetrical and linear conductance increase and decrease characteristics of multiple conductance levels by using resistance change memory, phase change memory, and ferroelectric memory. However, neural networks implemented in hardware may lag remarkably behind the recognition and classification accuracy of software-based deep neural networks due to the non-ideal characteristics of experimental memory devices. Hardware implementation using analog memory has the advantage such as high energy efficiency, but the advantage of neural network computational efficiency may be maximized only when software-level training accuracy is achieved.

In existing research, the non-volatile memory devices were suitable for only inference of training to update the weights of synapse devices and inference to recognize and classify images, objects, voices, etc. This is because the number of conduction levels required for efficient training is more than $2^{10}$ (approximately 1000) and the increase or decrease of synapse weights must be symmetrical and linear, there were physical and technological limitations for existing memory devices.

To overcome these limitations, conventional research performed training in software and moved synapse weight values to an analog memory array to perform only the inference function in hardware.

**DISCLOSURE OF THE INVENTION**

**TECHNICAL PROBLEM**

The technological object to be achieved by the present invention is to provide a synapse device of a charge storage type for deep neural network training which provides not only linear and symmetric weight updates, but also sufficient retention time and parallel on-chip training operations.

Additionally, the technological object to be achieved by the present invention is to provide a synapse device of a charge storage type for deep neural network training provides device-algorithm co-optimization by using efficient and realistic training algorithms to compensate for remaining device non-idealities such as drifting references and long-term retention loss.

In addition, the technological object to be achieved by the present invention is to provide a synapse device of a charge storage type for deep neural network training having software-level on-chip learning ability and software-level accuracy by implementing symmetrical and linear training characteristics without using existing analog memory devices.

The object to be solved by the present invention is not limited to the objects mentioned above, and other objects not mentioned will be understood by those skilled in the art from the description below.

According to one embodiment of the present invention, there is provided a synapse device of a charge storage type comprising: a weight capacitor having a first terminal and a second terminal and storing a voltage corresponding to the weight; four control transistors which change a voltage or a weight of the capacitor; a first output transistor including a first gate terminal coupled to the first terminal of the capacitor, and outputting a first drain current according to a voltage applied to the first gate terminal; and a second output transistor including a second gate terminal coupled to the second terminal of the capacitor, and outputting a second drain current according to the voltage applied to the second gate terminal, and wherein the weight may be read as the difference between the first drain current and the second drain current. Each of the first control transistor and the third transistor of the four control transistors may have a first source terminal and include a pass transistor which transmits a first voltage connected to the first source terminal to the weight capacitor, each of the second control transistor and the fourth transistor of the four control transistors may have a second source terminal and include a transistor which functions as a current source based on a ground connected to the second source terminal, each of the first control transistor and the fourth transistor may include a first drain terminal, the first drain terminals are connected to each other and to the first terminal of the weight capacitor, each of the second control transistor and the third transistor may include a second drain terminal, and the second drain terminals may be connected to each other and to the second terminal of the weight capacitor.

The first control transistor may be connected between the first voltage and the first terminal of the weighting capacitor, and connect the first voltage and the first terminal of the weighting capacitor in response to a first control signal, the second control transistor may be connected between the ground and the second terminal of the weight capacitor, and connect the ground and the second terminal in response to a second control signal, the third control transistor may be connected between the first voltage and the second terminal of the weighting capacitor, and connect the first voltage and the second terminal of the weighting capacitor in response to a third control signal, the fourth control transistor may be connected between the ground and the first terminal of the weight capacitor, and connect the ground and the first terminal in response to a fourth control signal, the first output transistor may have a third drain terminal connected to a first input line and a third source terminal connected to the first output line, the second output transistor may have a fourth drain terminal connected to a second input line and a fourth source terminal connected to a second output line, the first drain current of the first output transistor may be determined by the voltage of the first terminal of the weight capacitor, the voltage of the first input line, and the voltage of the first output line, and may be supplied to the first output line, and the second drain current of the second output transistor may be determined by the voltage of the second terminal of the weight capacitor, the voltage of the second input line, and the voltage of the second output line, and may be supplied to the second output line. An overdrive voltage which is relatively lower than the first voltage may be applied to the second control transistor and the fourth control transistor.

In one embodiment, the weight may increase in a positive direction through a potentiation update which operates by turning on the first control transistor and the second control transistor, and the weight may increase in the negative direction through a depression update which operates by turning on the third control transistor and the fourth control transistor. The weight may be determined by the discharge current of the second control transistor or the fourth control transistor, the pulse width applied to the second control transistor or the fourth control transistor, and the capacitance of the weight capacitor. The third control transistor may read the first drain current of the first output transistor through a read operation which is turned on, the first control transistor may read the second drain current of the second output transistor through a read operation in which is turned on, and determine the difference between the first drain current and the second drain current according to the weight, the first control transistor may read the third drain current of the first output transistor through a reference read operation which is turned on, the third control transistor may read the fourth drain current of the second output transistor through a reference read operation which is turned on. The difference between the third drain current and the fourth drain current may be determined as the reference conductance, and when the weight capacitor has the reference conductance, the voltage $V_{cap}$ of the weight capacitor may be 0. At least one of the potentiation update, the depression update, the read operation, and the reference read operation may be inverted. The voltage $V_{cap}$ of the weight capacitor may be reset to 0 by turning on the second control transistor and the fourth control transistor. The reset operation may be performed before the invert operation. The four control transistors, and the first and the second output transistors may be an amorphous InGaZnO FET (Field Effect Transistor), a polycrystalline InGaZnO FET, a single crystalline InGaZnO FET, or a C-axis grown crystal InGaZnO (C-axis aligned InGaZnO) FET. The nonlinearity of the synapse device may be adjusted according to the pulse conditions applied to the four control transistors.

According to another embodiment of the present invention, the driving method of a synapse device of the disclosed claim 1 may perform a reference read operation in the case of linear learning, and perform a reference read operation, a reset operations and an invert operation in the case of non-linear learning.

According to another embodiment of the present invention, a learning method of a neural network consisting of a core device array including $M \times N$ first synapse devices and an auxiliary device array including $M \times N$ second synapse devices of disclosed claim 1 may include a first step for generating an output value by applying forward propagation and back propagation methods in the core device array; a second step for firstly updating the auxiliary device array by applying a pulse corresponding to an output value from the core device array to the auxiliary device array; a third step for selecting a specific column of the auxiliary device array after the firstly updating, and for generating an output current from the specific column; a fourth step for converting each of output current into an input value of the core device array by performing a read operation and a reference read operation through the synapse device of each disclosed claim 1 of the specific column; and a fifth step for secondly updating a specific column of the core device array through the input value. The step for performing a reset operation or an invert operation according to a random variable by using the synapse device of disclosed claim 1 of each specific column of the auxiliary device array may be further included. The reset operation or the invert operation may not be performed in the case of linear learning, but may be performed in the case of non-linear learning. Alternatively, the reset operation or the invert operation may not be performed during the initial learning period but may be performed after the initial learning period. After the fifth step, the steps 1 to 5 may be repeatedly performed for the remaining columns of the core device array and the auxiliary device array.

## ADVANTAGEOUS EFFECTS

According to embodiments of the present invention, a charge storage type has a 6T1C structure including a weight capacitor; four control transistors for changing a voltage or a weight of the capacitor; a first output transistor including a first gate terminal coupled to the first terminal of the capacitor, and outputting a first drain current according to a voltage applied to the first gate terminal; and a second output transistor including a second gate terminal coupled to the second terminal of the capacitor, and outputting a second drain current according to the voltage applied to the second gate terminal. Therefore, it may provide sufficient retention time and parallel on-chip training operations as well as linear and symmetric weight updates.

Additionally, it may provide device-algorithm co-optimization by using efficient and realistic training algorithms to compensate for remaining device non-idealities such as drifting references and long-term retention loss.

In addition, software-level on-chip learning ability and software-level accuracy may be improved by implementing symmetrical and linear training characteristics without using existing analog memory devices.

In addition, when the synapse device of the present invention is used in a linear learning algorithm and a non-linear learning algorithm, the weight accumulated in the capacitor-based device having leakage may be efficiently transferred to the non-volatile memory, and leakage converging conductance may be read without the reference device array, which is essential for auxiliary device arrays by taking advantage of the 6T1C device. Therefore, improvement in integration may be expected. Since it reads leakage converging conductance as a reference, it has robust characteristics regarding retention time and may improve accuracy deterioration due to leakage.

Additionally, in the case of linear learning, accuracy deterioration due to asymmetry rarely occurs.

In addition, in the case of non-linear learning, an invert operation may be done stochastically to improve accuracy degradation due to asymmetry, and additionally, the asymmetry of the transistor in the synapse device 100 having a 6T1C structure may also be compensated. Additionally, it is possible to use the non-linear device's own weight regularization.

However, the effects of the present invention are not limited to the above effects and may be expanded in various ways without departing from the technological spirit and scope of the present invention.

## BRIEF DESCRIPTION OF THE DRAWINGS

FIG. 1A is a conceptual diagram illustrating a cranial nerve simulation calculation system according to an embodiment of the present invention.

FIG. 1B is a circuit diagram illustrating the synapse device 100 shown in FIG. 1A.

FIG. 2A is a diagram for explaining a structure and a manufacturing method of an IGZO (In-Ga-Zn-O) thin film transistor TFT according to an embodiment of the present invention.

FIG. 2B is a diagram for explaining a capacitor device structure and a manufacturing method according to an embodiment of the present invention.

FIG. 3A is an operation description for explaining a potentiation update operation to increase a weight of the synapse element 100 of the present invention.

FIG. 3B is an operation description for explaining a depression update operation to reduce a weight of the synapse element 100 of the present invention.

FIG. 3C and FIG. 3D are operation descriptions for explaining a read operation of the synapse device 100 of the present invention.

FIG. 3E and FIG. 3F are operation descriptions for explaining a reference read operation of the synapse element 100 of the present invention.

FIG. 3G is an operation description for explaining a reset operation (a reset method) of the synapse device 100 of the present invention.

FIG. 4A to FIG. 4E are diagrams for explaining a learning method of a core element using a synapse element 6T1C having linear characteristics according to the present invention.

FIG. 5A to FIG. 5F are diagrams for explaining a learning method of a core device using a synapse device 6T1C having non-linear characteristics of the present invention.

FIG. 6 is an image of a printed circuit board PCB for measuring synapse devices in an embodiment of the present invention.

FIG. 7A is a graph of the weight update results of a single synapse device having a 6T1C structure according to an embodiment of the present invention.

FIG. 7B is a diagram showing a weight update curve according to an embodiment of the present invention.

FIG. 7C is a graph showing the retention characteristic results of a single synapse device having a 6T1C structure according to an embodiment of the present invention.

FIG. 7D is a graph showing measurement results in an initial cycle for measuring cycling durability of a single synapse device having a 6T1C structure according to an embodiment of the present invention.

FIG. 7E is a graph of measurement results obtained by applying $10^9$ update pulses to a single synapse device having a 6T1C structure according to an embodiment of the present invention.

FIG. 8A is a flowchart for linear regression training according to an embodiment of the present invention. FIG. 8B is a graph of evaluation results of loss and error throughout training according to an embodiment of the present invention.

FIG. 9A is a result graph of conductance-conductance change type obtained under various measurement conditions according to an embodiment of the present invention.

FIG. 9B is a graph showing the accuracy of the device according to retention characteristics by applying the conventional Tiki-taka algorithm after reflecting various values within the NL range of the synapse device having a 6T1C structure according to an embodiment of the present invention.

FIG. 9C is a graph showing the accuracy of the device according to the retention characteristics obtained by applying the proposed invention at NL=0.2 and NL=2.0 according to an embodiment of the present invention.

FIG. 10 is a diagram for explaining a method for setting reference conductance according to an embodiment of the present invention.

FIG. 11A and FIG. 11B are result graphs obtained by comparing the learning results according to the linear learning method of the present invention and the conventional method at various retention levels in the LENET5 model and the MLP model, respectively.

FIG. 12A and FIG. 12B are result graphs comparing non-linear learning results for a case that an invert operation and a reset operation are performed and a case that an invert operation and a reset operation are not performed in the LENET5 model.

## BEST MODE FOR CARRYING OUT THE INVENTION

Hereinafter, the embodiments of the present invention will be described in detail with reference to the accompanying drawings.

The embodiments of the present invention to be described below are provided to more clearly explain the present invention to those skilled in the art, and the scope of the present invention is not limited by the following embodiments, and the embodiments may be modified in many different forms.

The terms used in this specification are used to describe specific embodiments and are not intended to limit the present invention. The terms indicating a singular form used herein may include plural forms unless the context clearly indicates otherwise. Also, as used herein, the terms, "comprise" and/or "comprising" specify the presence of the stated shape, step, number, operation, member, element, and/or group thereof and does not exclude the presence or addition of one or more other shapes, steps, numbers, operations, elements, elements and/or groups thereof. In addition, the term, "connection" used in this specification means not only a direct connection of certain members, but also a concept including an indirect connection in which other members are interposed between the members.

The terms such as the first or the second may be used to describe various components, but the components should not be limited by the terms. The above terms may be used only for the purpose of distinguishing one component from another component, for example, a first component may be referred to as a second component without departing from the scope of rights according to the concept of the present invention, and similarly, the second component may also be referred to as the first component.

In addition, in the present specification, when a member is said to be located "on" another member, this arrangement includes not only a case in which a member is in contact with another member, but also a case where another member exists between the two members. As used herein, the term, "and/or" includes any one and all combinations of one or more of the listed items. In addition, the terms of degree such as "about" and "substantially" used in the present specification are used as a range of values or degrees, or as a meaning close thereto, taking into account inherent manufacturing and substance tolerances, and exact or absolute figures provided to aid in the understanding of this application are used to prevent the infringers from unfairly exploiting the stated disclosure.

Hereinafter, embodiments of the present invention will be described in detail with reference to the accompanying drawings. A size or a thickness of areas or parts shown in the accompanying drawings may be slightly exaggerated for clarity of the specification and convenience of description. The same reference numbers indicate the same configuring elements throughout the detailed description.

Hereinafter, the present invention will be described in detail by explaining preferred embodiments of the present invention with reference to the accompanying drawings.

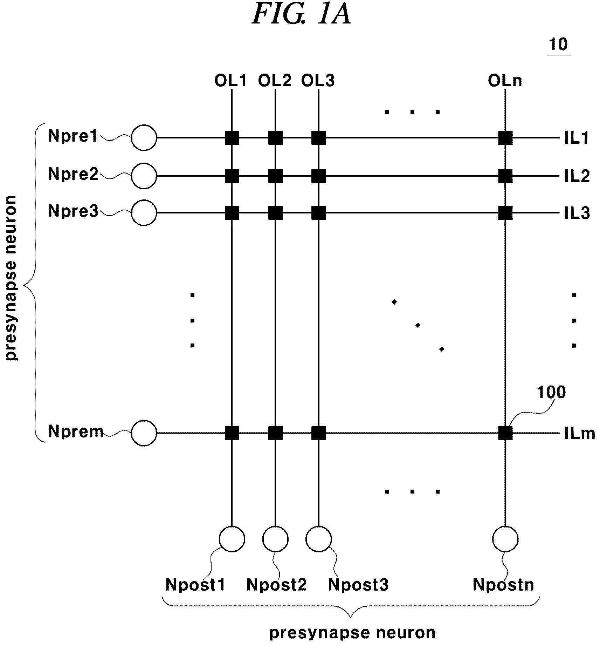

FIG. 1A is a conceptual diagram illustrating a cranial nerve simulation calculation system according to an embodiment of the present invention. This is a configuration diagram of neurons and synapses required for cranial nerve simulation calculations, and presynaptic neurons send input data (voltage) to a crossbar-shaped synaptic cell array, and postsynaptic neurons send current values (I= GV, G reads the conductance value of each synapse (stored in the form of an array) from the synaptic cell array. In the update method of the conductance value of each synapse, the update value may be determined by forward propagation/backward propagation depending on the neural network calculation method, or spike-timing dependent plasticity learning rules may be locally used.

Referring to FIG. 1A, the cranial nerve simulation operation system 10 includes presynapse neurons (Pre-synapse Neurons, $N_{pre1}$ to $N_{prem}$), postsynapse neurons (Postsynapse Neurons $N_{post1}$ to $N_{postn}$), and a plurality of synapse devices 100.

In FIG. 1A, for convenience, the lines connected to the presynapse neurons ($N_{pre1}$ to $N_{prem}$) are represented as the input lines ($I_{L1}$ to $I_{Lm}$), and the lines connected to the postsynapse neurons ($N_{post1}$ to $N_{postn}$) are expressed as the output lines ($O_{L1}$ to $O_{Ln}$). However, this is only for the purpose of distinguishing between the lines connected to presynapse neurons ($N_{pre1}$ to $N_{prem}$) and the lines connected to postsynapse neurons $N_{post1}$ to $N_{postn}$).

For example, during a forward propagation operation in which an input value is transmitted from presynapse neurons ($N_{pre1}$ to $N_{prem}$) to post-postsynapse neurons ($N_{post1}$ to $N_{postn}$) through the synapse devices 100, the input lines ($I_{L1}$ to $I_{Lm}$) may operate as the input lines and the output lines ($O_{L1}$ to $O_{Ln}$) may operate as the output lines.

Conversely, during a backward propagation operation in which input values are transmitted from the post-synapse neurons ($N_{post1}$ to $N_{postn}$) to the presynapse neurons ($N_{pre1}$ to $N_{prem}$) through the synapse devices 100, the input lines ($I_{L1}$ to $I_{Lm}$) may operate as the output lines and the output lines ($O_{L1}$ to $O_{Ln}$) may operate as the input lines.

Hereinafter, unless specifically mentioned, the concept of the present invention will be described under the assumption of a forward propagation operation, but the concept of the present invention is not limited thereto.

The synapse device 100 is provided between any one of the presynapse neurons ($N_{pre1}$ to $N_{prem}$) and any one of the postsynapse neurons ($N_{post1}$ to $N_{postn}$).

Although omitted in FIG. 1A, the synapse device 100 receives control signals from an external circuit (a peripheral circuit which is not shown).

An external circuit (not shown) updates the weight of the synapse device 100 by repeatedly outputting control signals to the synapse device 100 during training. In other words, an external circuit (not shown) may potentiate or depress the synapse device 100 by outputting control signals having a predetermined waveform to the synapse device 100.

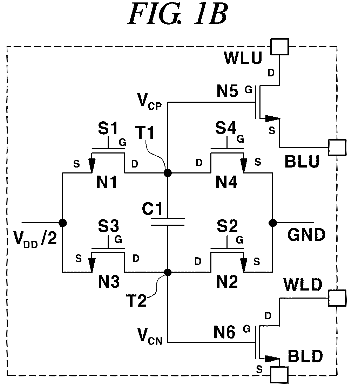

When training the brain nerve simulation operation system 10, the external circuit (not shown) sets the voltage ($V_{cap}$) across the capacitor (C1 in FIG. 1B) included in the synapse device 100 which will be described later, to the target voltage. At this time, the potentiation or the depression operation may be repeatedly performed a number of times corresponding to the difference between the charged voltage and the target voltage.

FIG. 1B shows a circuit diagram of the synapse device 100 shown in FIG. 1A. As a non-limiting example, the synapse device 100 may be connected between any one of the presynapse neurons and any one of the postsynapse neurons constituting the cranial nerve simulation operation system 10 so that the synapse weights may be stored/updated.

Referring to FIG. 1B, the single synapse device 100 may be composed of six transistors (N1 to N6) and one capacitor (hereinafter referred to as a '6T1C' structure). The weight capacitor C1 acts as a memory in the cell and may store the weight as a form of a charge. Among the six transistors (N1 to N6), two output transistors N5, N6 operate as a read FET to perform a read operation and a reference read operation on the weight stored in the capacitor C1, which will be described later, and the other four control transistors (N1 to N4) play a role in changing the capacitor voltage $V_{cap}$ through a potentiation update and a depression update, which will be described later. In the process for changing the voltage $V_{cap}$ of both ends T1, T2 of the weight capacitor C1. Each of the first control transistor N1 and the third transistor N3 may operate as a Pass Gate FET to transmit a first voltage $V_{dd}/2$ to the first terminal T1 and the second terminal T2 of the weight capacitor C1 through the drain D terminal,_and the second control transistor N2 and the fourth control transistor N4 may perform a role of a current source FET for discharging a constant current.

Specifically, the weight capacitor C1 includes a first terminal T1 and a second terminal T2 and may store a voltage corresponding to the weight. The weight may correspond to the voltage difference between the first terminal T1 and the second terminal T2. The voltage difference refers to the difference between the voltage $V_{CP}$ applied to the first terminal T1 and the voltage $V_{CN}$ applied to the second terminal T2.

The four control transistors (N1 to N4) may change the voltage $V_{cap}$ or weight of the weight capacitor C1, and when N1, N2, and N4 are turned off and only N3 is turned on, the first output transistor N5 may output a first read current corresponding to the weight of the weight capacitor, and also in the case of the second output transistor N6, it may output a second read current corresponding to the weight of the weight capacitor when only N1 is turned on and N2 to N4 are turned off. In addition, the first output transistor N1 may include a first gate terminal G1 coupled to the first terminal T1 of the capacitor C1, and the second output transistor N2 includes a second gate terminal G2 is coupled to the second terminal T2 of the capacitor C1. The control signals S1, S2, S3, and S4 may be applied to each of the four control transistors N1 to N4 through gate terminals.

The first control transistor N1 and the third transistor N3 may have a first source terminal S1, and may include a pass transistor which transmit the first voltage $V_{dd}/2$ connected to the source terminal S to the capacitor C1. The second control transistor N2 and the fourth transistor N4 have a second source terminal S, and may include a transistor which functions as a current source based on ground GND connected to the second source terminal S. The first control transistor N1 and the fourth transistor N4 may include a first drain terminal D, the first drain terminal D may be connected to the first terminal T1 of the capacitor C1. The second control transistor N2 and the third transistor N3 may include a second drain terminal D, and the second drain terminal D may be connected to the second terminal T2 of the capacitor C1.

In addition, the first control transistor N1 may be connected between the first voltage $V_{dd}/2$ and the first terminal T1 of the capacitor C1, and may connect the first voltage and the first terminal T1 of the capacitor C1 in response to the first control signal S1. The first terminal T1 of the capacitor may be connected. The second control transistor N2 may be connected between ground GND and the second terminal T2 of the capacitor C1, and may connect the ground and the second terminal T2 in response to the second control signal S2. The third control transistor N3 may be connected between the first voltage $V_{dd}/2$ and the second terminal T2 of the capacitor C1, and connect the first voltage $V_{dd}/2$ and the second terminal T2 of the capacitor C1 in response to the third control signal S3. The fourth control transistor N4 may be connected between ground GND and the first terminal T1 of the capacitor C1, and connect ground GND and the first terminal T1 in response to the fourth control signal S4.

The first output transistor N5 has a third drain terminal D connected to a first input line WLU to which one presynapse neuron is connected, and a first output line to which one of postsynapse neurons is connected, and a third source terminal S connected to the first output line BLU to which one of the postsynapse neurons is connected. The second output transistor N6 has a fourth drain terminal D connected to a second input line WLD to which one of synapse neurons is connected, and a fourth source terminal S connected to a second output line BLD to which one postsynapse neuron is connected.

The first read current of the first output transistor N5 is determined by the voltage $V_{CP}$ of the first terminal T1 of the capacitor C1, the voltage of the first input line WLU, and the voltage of the first output line BLU, and may be supplied to the first output line BLU. The second read current of the second output transistor N6 is determined by the voltage of the second terminal T2 of the capacitor $V_{CN}$, the voltage of the second input line WLD, and the voltage of the second output line BLD, and may be supplied to the second output line BLD.

In order to implement a charge storage device which satisfies retention requirements without loss of learning accuracy at a reasonable device size, it is necessary to reduce the area of the capacitor based on a sufficiently small transistor leakage current. For achieving this purpose, the present invention uses an In-Ga-Zn-Oxide Thin Film Transistor (IGZO TFT), which has sufficient mobility and very low leakage current. IGZO TFT, which has a larger bandgap than silicon, operates in accumulation mode, has almost no hole tunneling gate leakage current, and has a large hole effective mass, making it suitable for use as intrinsic NMOS. As a non-limiting example, IGZO TFT may also be utilized as PMOS by changing the dopant. Additionally, the weight capacitor C1 includes a Metal-Insulator-Metal (MIM) capacitor and may be manufactured by depositing a high-k dielectric insulator through an Atomic Layer Deposition (ALD) process. The amount of charge which a capacitor may store and the leakage current may be determined depending on the substance properties of the metal substance which acts as an electrode and the high-k dielectric which acts as an insulator, the structure of the manufactured capacitor, and the voltage conditions applied to both ends of the capacitor. At this time, in order to improve the retention characteristics which preserve the charges stored in the capacitor, a substance having a high energy gap which may control various mechanisms causing leakage current while increasing the dielectric constant of the insulator may be used.

In addition, after training of the synapse device 100 is completed, the weights set in the synapse device 100 must be maintained to enable inference according to the learning results. Since the weight is stored as the voltage across the capacitor C1 ($V_{cap} = V_{CP} - V_{CN}$), it is preferable that the first to fourth control transistors N1 to N4 have low off-current, that is, a low leakage current in the off state. Preferably, the first to fourth control transistors (N1 to N4) and the first to second output transistors (N5, N6) may be implemented as an amorphous InGaZnO FET, a polycrystalline InGaZnO FET, or a single crystalline InGaZnO FET, or may be implemented as a metal oxide transistor including at least any one of In, Ga , Zn, Sn, Al, Hf, Zr, Si, and O. In particular, the C-axis growth crystal InGaZnO FET was announced to have an off-current of about 10-24 [$A/\mu m$], and this is because the leakage current components caused by a multi-carrier accumulation mode operation device of a metal oxide transistor, high band gap, high sub-gap state near the valence band, and high hole effective mass are initially blocked.

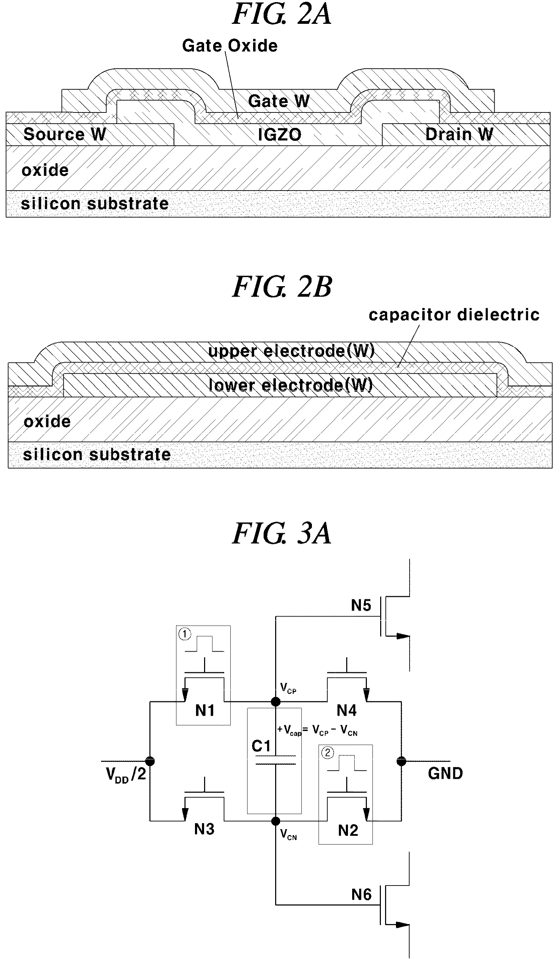

Hereinafter, the update/read/reference read/invert/reset operations of the synapse device 100 will be described in detail with reference to FIGS. 3A to 3G, which will be described later. Positive update of the capacitor voltage by storing positive charges in the synapse device for potentiation of the synapse weight connection intensity of the artificial neural network is called as a potentiation update. A negative update of the capacitor voltage by storing negative charges in the synapse element for depression the synapse weight connection intensity of the artificial neural network is called a depression update.

FIG. 2A is a diagram for explaining a structure and a manufacturing method of an IGZO (In-Ga-Zn-O) thin film transistor TFT according to an embodiment of the present invention.

Referring to FIG. 2A, a charge storage type synapse device which performs a weight update operation may be manufactured by using IGZO TFTs (N1 to N6) having excellent low leakage current characteristics. As a non-limiting example, IGZO TFT has a Top-Gate Staggered structure, and sputtering was performed at for amorphous IGZO deposition by 2.44W/ $cm^2$ RF Bias under 1Pa Ar 100sccm atmosphere by using a sputtering device equipped with a target composed of In:Ga:Zn = 1:1:1.

Specifically, a manufacturing method of the IGZO TFT device may include a silicon substrate oxidation process using wet oxidation (oxidation layer with a thickness of approximately 5000 Å), a metal deposition (tungsten W metal layer with a thickness of approximately 200 Å) process, a source and drain patterning and a dry etching process, and a channel deposition process using sputtering (e.g., amorphous IGZO with a thickness of approximately 10 nm), a gate insulating layer deposition process using ALD (e.g., hafnium oxide with a thickness of approximately 10 nm), and a gate terminal formation process (e.g., tungsten W metal layer with a thickness of approximately 300 Å).

At this time, in order to effectively control the hydrogen concentration of IGZO, the IGZO TFT may be manufactured after manufacturing the capacitor element, which will be described later. This is to prevent the IGZO channel characteristics from being affected by hydrogen generated during the TMA (trimethylaluminum)-based ALD (Atomic Layer Deposition) process, and thus deteriorating the characteristics of the IGZO TFT. When excessive hydrogen is injected into the IGZO channel, as the electron carriers increase and conductivity characteristics appear, it is important to secure process conditions which effectively control this.

FIG. 2B is a diagram for explaining a capacitor device structure and a manufacturing method according to an embodiment of the present invention.

Referring to FIG. 2B, the weight of the charge storage synapse device may be stored in the capacitor C1 through the IGZO TFT. In this study, a Metal-Insulator-Metal (MIM) capacitor using high-ê dielectric is used to secure high capacitance at a level which does not cause problems in verifying the operation of a new structure of synapse using IGZO TFT. High- ê dielectric was deposited at approximately 250°C by using a TMA-based source and $O_3$ reactant.

A specific manufacturing method of a capacitor device may include a silicon substrate oxidation process using wet oxidation (oxidation layer approximately 5000Å thick), lower electrode layer deposition (tungsten W metal layer approximately 200Å thick) process, a lower electrode patterning and dry etching process, an insulating layer deposition process (e.g., hafnium oxide approximately 10 nm thick) using ALD, an upper electrode layer deposition process (e.g. a tungsten W metal layer approximately 300 Å thick), an upper electrode patterning and dry etching process. At this time, the high dielectric constant oxide to be used as the capacitor insulator may be deposited to the required thickness through ALD, and a capacitor using an appropriate high dielectric constant substance may be manufactured considering the capacity and leakage current requirements of the synapse capacitor.

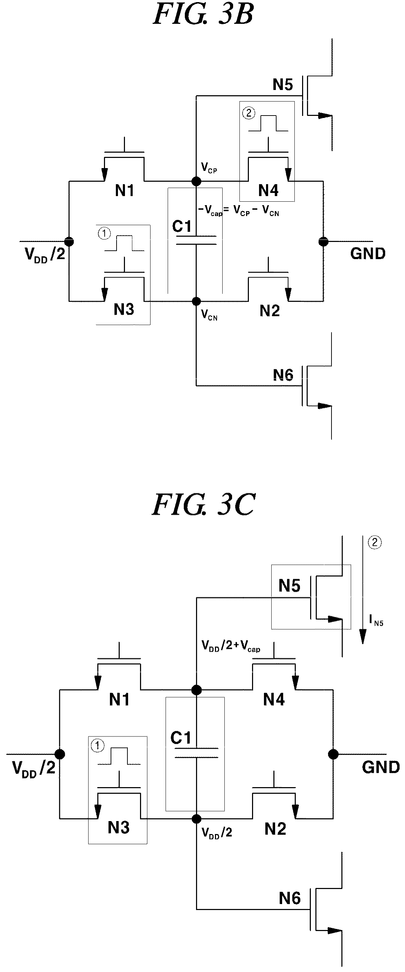

FIG. 3A is an operation description for explaining a potentiation update operation to increase a weight of the synapse element 100 of the present invention. FIG. 3B is an operation description for explaining a depression update operation to reduce a weight of the synapse element 100 of the present invention.

Referring to FIG. 3A, during the potentiation update, it is possible to set a voltage $V_{CP}$ to $V_{dd}/2$ at the first terminal T1 of the weight capacitor C1 by applying a pulse to the gate terminal G of the first control transistor N1. Then, it is possible to increase the potential difference $V_{cap}$ ($V_{CP}-V_{CN}$) across the weight capacitor C1 in the positive direction by applying a pulse to the gate terminal G of the second control transistor N2.

The 6T1C structure requires a synapse device configuration using a transistor which may only play the NMOS role, without a transistor which may play the PMOS role. To ensure linear and gradual update characteristics, the source of the NMOS transistor needs to be a fixed voltage. In the 6T1C structure, the transistor N1 plays the role making the capacitor bottom node voltage $V_{CN}$ higher than or equal to ground, and as a result of it, enables the second transistor N2 to perform weight updates consistently according to the gate pulse voltage. Update is performed through a pulse current by using the second control transistor N2 connected between the bottom node T2 of the capacitor C1, and the ground node GND, and since an potentiation enable operation using the first control transistor N1 boosts up a top node voltage $V_{CP}$ of a capacitor to $V_{dd}/2$, the capacitor voltage change may be potentiated up to $+V_{dd}/2$.

Referring to FIG. 3B, during the depression update, it is possible to set a voltage $V_{CN}$ (lower) to the second terminal T2 of the weight capacitor C1 terminal voltage) to $V_{dd}/2$ by applying a pulse to the gate terminal G of the third control transistor N3. Then, it is possible to lower the potential difference $V_{cap}(=V_{CP}-V_{CN})$ between both ends of the weight capacitor C1 in the negative direction by applying a pulse to the fourth control transistor N4.

In other words, the third control transistor N3 is turned on to boost the bottom node voltage $V_{CN}$ of the capacitor C1 to $V_{dd}/2$, so that the top node voltage $V_{CP}$ of the capacitor C1 may not be set lower than ground (Depression Enable). Update is performed through pulse current by using the fourth control transistor N4 connected between the top node T1 of the capacitor C1 and the ground node GND, and since Depression Enable operation performed by using the third control transistor N3 boosts up the lower node voltage $V_{CN}$ of this capacitor to $V_{dd}/2$, the capacitor voltage change may be depressed up to $-V_{dd}/2$.

During the potentiation update and depression update operations, when stochastic pulses of control transistors N1 N3 and N2 N4 are generated simultaneously, weight update is performed and the voltage change per update may be calculated as following [Equation 1]

$$[\text{Equation 1}]$$

$$\Delta V_{cap} = \frac{i_{N2,N4} \times t_{pw}}{C}$$

Here, $i_{N2,N4}$ $i_{N2,N4}$ is the discharge current from the control transistor N2 and N4, respectively, and $t_{pw}$ $t_{pw}$ is the pulse width applied to the control transistor N2 N4, and C is the capacitance of the capacitor C1.

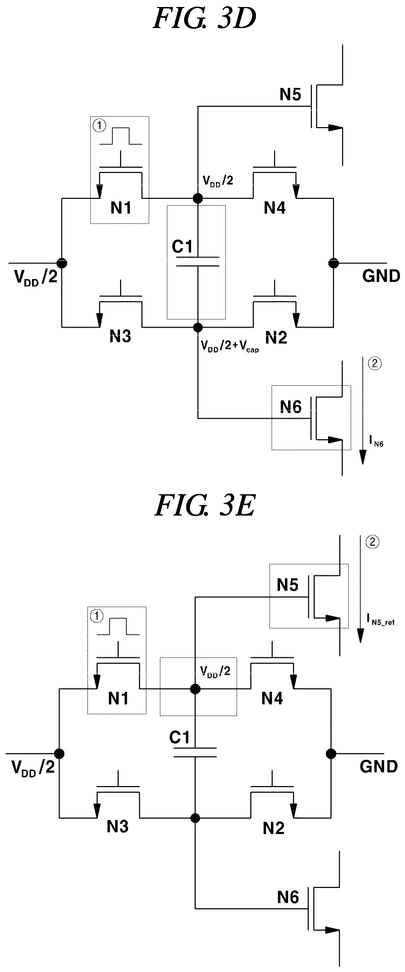

FIG. 3C and FIG. 3D are operation descriptions for explaining a read operation of the synapse device 100 of the present invention. The read operation may be divided into a process for reading the current flowing through the first output transistor N5 and a process for reading the current flowing through the second output transistor N6.

Referring to FIG. 3C, for a read operation from the first output transistor N5, it is possible to set the voltage at the top node T1 and the bottom node T2 of the capacitor C1 to $V_{dd}/2+V_{cap}$ and $V_{dd}/2$, respectively by applying a pulse to the third control transistor N3. When a $V_{dd}/2+V_{cap}$ voltage is applied to the gate terminal G of the first output transistor N5, it is possible to measure the first weight current $I_{N5}$ by applying a small bias between the source S and drain D of the first output transistor N5 to obtain the first weight. That is, the top node T1 of the capacitor C1 is connected to the gate terminal G of the first output transistor N5, and it is possible to generate a drain current of the first output transistor N5 which varies depending on the potential difference between the two ends of the capacitor by applying a low voltage of about 0.1 V to the drain terminal D of the first output transistor N5. At this time, as $V_{dd}/2$ voltage is applied to the bottom node T2 of the capacitor C1 by applying a pulse voltage to the gate terminal G of the third control transistor N3, the first output transistor N5 may operate in the linear region (triode region), and as a result of it, the first current $I_{N5}$ may behave linearly according to the gate voltage.

Referring to FIG. 3D, after reading the above-described first weight current $I_{N5\_ref}$, a read operation may be performed on the second output transistor N6. For a read operation from the second output transistor N6, a pulse is applied to the first control transistor N1 to increase the voltages of the upper node T1 and lower node T2 of the capacitor C1 to $V_{dd}/2$ and $V_{dd}/2-V_{cap}$ Vdd/2, respectively. When $V_{dd}/2-V_{cap}$ Vdd/2 voltage is applied to the gate terminal G of the second output transistor N6, it is possible to measure the second current $I_{N6}$ by applying small bias between the source S and drain D of the second output transistor N6. That is, the bottom node T2 of the capacitor C1 is connected to the gate terminal G of the second output transistor N6, and it is possible to generate a drain current of the second output transistor N6 which changes depending on the potential difference between the two ends of the capacitor by applying a low voltage of about 0.1 V to the drain terminal D of the second output transistor N6. At this time, since $V_{dd}/2$ voltage is applied to the top node T1 of the capacitor C1 by applying a pulse voltage to the gate terminal G of the first control transistor N1, the second output transistor N6 may operate in the linear region section. Accordingly, the second weight current $I_{N6}$ may behave linearly according to the gate voltage.

At this time, in order to represent both positive and negative weights, the weight $W_{ij}$ is defined as Equation 2 below obtained by subtracting the first current $I_{N5}$ and the second current $I_{N6}$.

[Equation 2]

$$W_{ij} = I_{ijN5} - I_{ijN6} \quad (2)$$

Here, i,j represent the row and column of the array, $I_{ijN5}$ represents the first weight current $I_{N5\_ref}$ in the array, and $I_{ijN6}$ represents the second weight current $I_{N6\_ref}$ in the array.

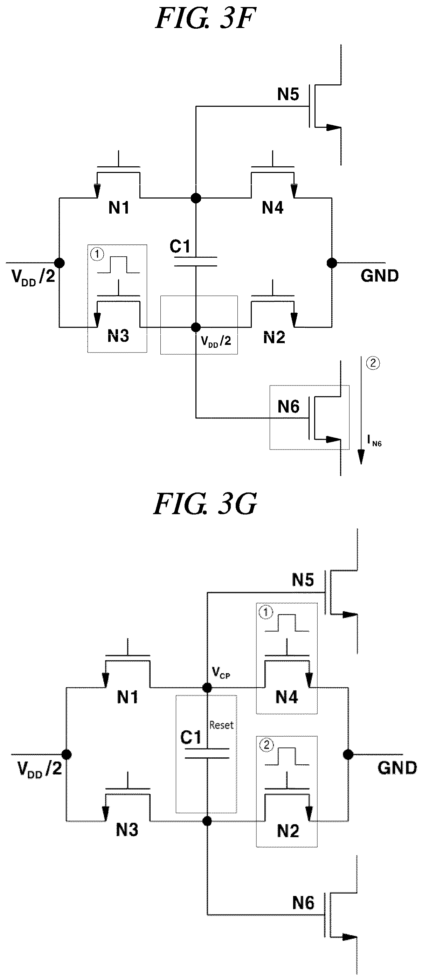

FIG. 3E and FIG. 3F are operation descriptions for explaining a reference read operation of the synapse element 100 of the present invention. When $V_{cap\_ij}=0$, the matching conductance is referred to as a reference. The reference read operation may refer to an operation for reading the matching conductance when $V_{cap\_ij}=0$.

FIG. 3E and FIG. 3F are operation descriptions for explaining a reference read operation of the synapse device 100 of the present invention.

Referring to FIG. 3E, for a reference read operation from the first output transistor N5, the voltage at the top node T1 of the capacitor C1 is set to Vdd/2 by applying a pulse to the first control transistor N1. When $V_{dd}/2$ voltage is applied to the gate terminal G of the first output transistor N5, it is possible to measure to generate the first reference current $I_{N5\_ref}$ by applying a small bias between the source S and drain D of the first output transistor N5. That is, the top node T1 of the capacitor C1 is connected to the gate terminal G of the first output transistor N5, and it is possible to generate a drain current of the first output transistor N5 which may flow due to $V_{dd}/2$ voltage applied to the gate terminal G of the first output transistor N5 by applying a low voltage of about 0.1 V to the drain terminal D of the first output transistor N5.

Referring to FIG. 3F, after reading the above-described first reference current $I_{N5\_ref}$, a reference read operation may be performed on the second output transistor N6. For a reference read operation from the second output transistor N6, a pulse is applied to the third control transistor N3 to set the voltage at the bottom node T2 of the capacitor C1 to $V_{dd}/2$. When a $V_{dd}/2$ voltage is applied to the gate terminal G of the second output transistor N6, it is possible to measure the second reference current $I_{N6\_ref}$ by applying a small bias between the source S and drain D of the second output transistor N6. That is, the bottom node T2 of the capacitor C1 is connected to the gate terminal G of the second output transistor N6, and it is possible to generate a drain current of the second output transistor N6 which may flow due to the Vdd/2 voltage applied to the gate terminal G of the second output transistor N5 by applying a low voltage of about 0.1 V to the drain terminal D of the second output transistor N6. 5.

Here, the conductance (hereinafter referred to as 'reference conductance' or 'leakage converging conductance') in a situation where no charge is accumulated in the capacitor C1, that is, when $V_{cap}=0$, may be read without an additional reference array by calculating the difference between the first reference current $I_{N5\_ref}$ and the second reference current $I_{N6\_ref}$. The present invention may stably read 'reference conductance' by using leakage converging conductance in a device having a 6T1C structure.

In addition, the device 100 of the 6T1C structure of the present invention may perform an invert operation. Specifically, the potentiation update operation of FIG. 3A is performed by turning on the first and second transistors (N1 and N2), and the depression update operation of FIG. 3B is performed by turning on the third and fourth transistors (N3 and N4). Here, the potentiation update operation through the invert operation may be performed by turning on the third and fourth transistors (N3, N4), and the depression update operation of FIG. 3B may be performed by turning on the first and second transistors (N1, N2).

Similarly, the read operation of FIGS. 3C and 3D may be performed by turning on the third transistor to read the first weight current $I_{N5}$ and then turning on the first transistor to read the second weight current $I_{N6}$. Here, a read operation may be performed through an invert operation by turning on the first transistor to read the second weight current $I_{N6}$ and then turning on the third transistor to read the first weight current $I_{N5}$.

Similarly, the reference read operation in FIG. 3E and FIG. 3F may be performed by turning on the first transistor to read the first reference current $I_{N5\_ref}$ and then turning on the third transistor to read the second reference current $I_{N6\_ref}$. Here, the reference read operation through the invert operation may be performed by turning on the third transistor to read the second reference current $I_{N6\_ref}$ and then turning on the first transistor to read the first reference current $I_{N5\_ref}$. The switching on/off operation of the control transistors (N1 to N4) and output transistors (N5, N6) for the above-described update operation, read operation, reference read operation, and invert operation is described as [Table 1] below.

[Table 1]

| | Invert method | |
|---|---|---|
| **Update** | Potentiation: N1 & N2 on $\quad$ Depression: N3 & N4 on $\xleftrightarrow{invert}$ | Potentiation: N3 & N4 on Depression: N1 & N2 on |
| **Read** | $I_1 - I_2$ $I_1$ : only N3 on $\to$ N5 read $I_2$: only N1 on $\to$ N6 read | $\xleftrightarrow{invert}$ | $I_2 - I_1$ $I_1$ : only N3 on $\to$ N5 read $I_2$: only N1 on $\to$ N6 read |
| **Reference read** | $I_1 - I_2$ $I_1$ : only N1 on $\to$ N5 read $I_2$: only N3 on $\to$ N6 read | $\xleftrightarrow{invert}$ | $I_2 - I_1$ $I_1$ : only N1 on $\to$ N5 read $I_2$: only N3 on $\to$ N6 read |

It is possible to improve accuracy deterioration due to asymmetry which may occur because the values of symmetry conductance and leakage converging conductance are different from each other when the reference read operation is performed by performing an invert operation, Additionally, variations in transistors within the device may be offset. In addition, integration may be improved without the need for an additional reference array.

FIG. 3G is an operation description for explaining a reset operation (a reset method) of the synapse device 100 of the present invention.

Referring to FIG. 3G, since all charges accumulated in the weight capacitor C1 are lost by turning on only the second control transistor N2 and the fourth control transistor N4, it is possible to reset to $V_{cap}$ to 0V. Preferably, the reset operation should be performed before the invert operation. If the reset operation is performed after the invert operation, this is to prevent the weight corresponding to the previously accumulated charge from being read under a state that a sign is inverted.

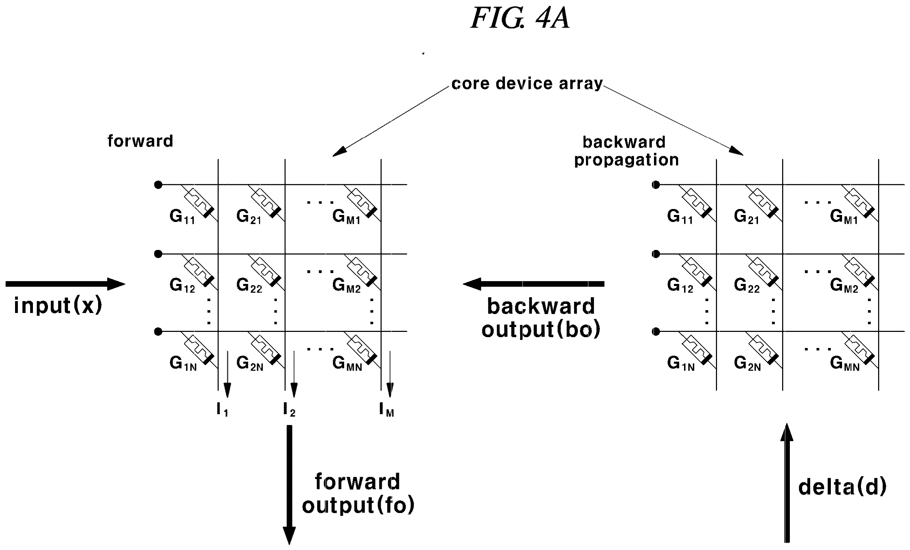

FIG. 4A to FIG. 4E are diagrams for explaining a learning method of a core element using a synapse element 6T1C having linear characteristics according to the present invention. Linear learning and non-linear learning may be performed through a core device array (or inference cell array) and an auxiliary device array, where a plurality of synapse devices may be arranged in a column (N) $\times$ row (M). Here, M and N are natural numbers. Additionally, the synapse devices of the core device array and the auxiliary device array may be the same or different from each other. Preferably, the synapse device of the core device array may use a conventional synapse device, and the synapse device of the auxiliary device array may use the 6T1C device described above. Alternatively, both of the synapse devices of the core device array and the auxiliary device array may use the 6T1C device described above.

Referring to FIG. 4A, first of all, the output value may be obtained by applying forward propagation and backpropagation methods in the core device array. Specifically, in the core device array, a forward output value (fo) may be outputted by inputting the first input value (input(x)), and a backward output value (bo) may be outputted by inputting the second input value (delta(d)). The backward output value (bo) may be a back propagated error. The algorithm for determining the update amount according to forward propagation and backward propagation methods may refer to the conventionally known technologies.

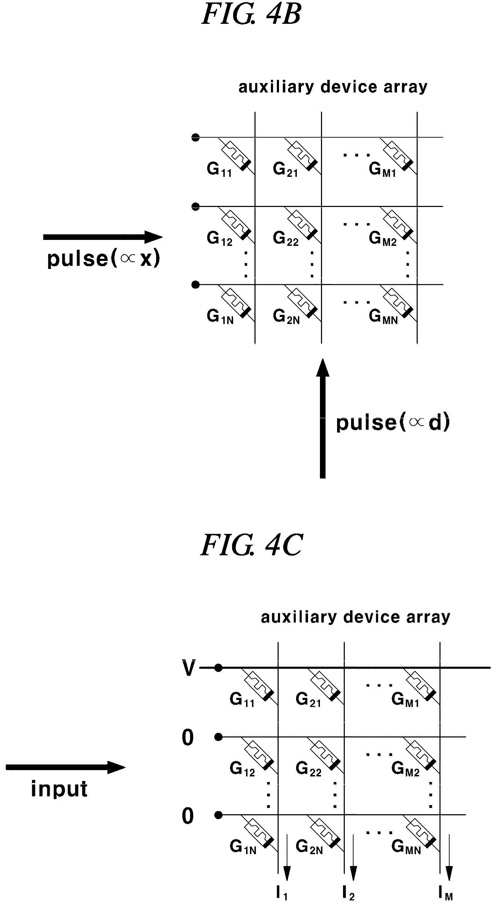

Referring to FIG. 4B, after FIG. 4A, an update may be performed in the auxiliary device array (6T1C array) by generating pulses based on input values (x, d) obtained based on forward propagation and backward propagation in the core device array. That is, the pulses proportional to the x and d values are input to the auxiliary device array, and a fully-parallel update may be performed according to a pulse overlap method. You may refer to general RPU (resistive processing units) update technology.

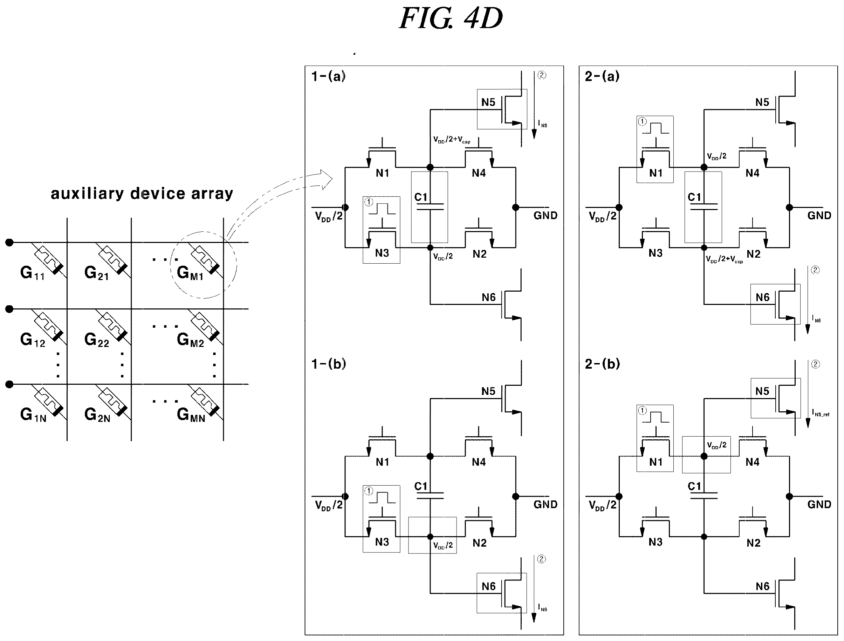

Referring to FIG. 4C, after the update described in FIG. 4B, a specific column of the auxiliary device array may be selected through an input process to obtain an output current from each element of the specific column. For example, in FIG. 4C, a predetermined pulse voltage V is supplied to the first column and an OV pulse voltage is supplied to the remaining columns. Thus, the output currents $(I_1, I_2, \odot, I_M)$ may be obtained from the devices $(G_{11}, G_{21}, ..., G_{M1})$ placed in the first column, respectively. Here, p is defined as p = Output $(I_1, I_2,...,I_M) \times$ transfer_learining_rate. The output currents $(I_1, I_2,...,I_M)$ may be converted to p through a read operation and a reference read operation disclosed in FIG. 4D, which will be described later.

Referring to FIG. 4D, 1-(a) and 2-(a) are the read operations of FIG.s 3c and 3d described above, and 2-(b) and 2-(b) are the reference read operations of FIG. 3E and FIG. 3F described above. Refer to the detailed operations of FIGS. 3C to 3F for detailed descriptions of the read operation and the reference read operation. The post-processing operation for the above-described p conversion may be (Output$_{1-(a)}$ - Output$_{2-(a)}$ - (Output$_{1-(b)}$ - Output$_{2-(b)}$) (hereinafter referred to as the first operation) or (Output$_{1-(a)}$ + OUtput$_{1-(b)}$) - (Output$_{2-(a)}$ + Output$_{2-(b)}$)(hereinafter referred to as the second operation).

Here, Output$_{1-(a)}$ is the current $I_{N5}$ output from the circuit operation of 1-(a), Output$_{1-(b)}$ is the current $I_{N6\_ref}$ output from the circuit operation of 1-(b), Output$_{2-(a)}$ is the current $I_{N6}$ output from the circuit operation of 2-(a), and Output$_{2-(b)}$ is the current $I_{N5\_ref}$ output from the circuit operation of 2-(b). Preferably, the result value of the first operation and the result value of the second operation may be the same. In the second operation, the term, (Output$_{1-(a)}$ + Output$_{1-(b)}$) means that the circuit operation of 1-(a) and the circuit operation of 1-(b) are performed simultaneously, and the term, (Output$_{2-(a)}$ + Output$_{2-(b)}$) means that the circuit operation of 2-(a) and the circuit operation of 2-(b) are performed simultaneously. In the case of the second operation, it may reduce the time required for reading because it is performed simultaneously at every read operation. However, there are cases where it is not necessary to read the reference during each read operation, and it is necessary to limit simultaneous reading in consideration of the problems in circuit operation. Therefore, in the first operation, the read operation may be performed separately as in the (Output$_{1-(a)}$ - Output$_{2-(a)}$) and (Output$_{1-(b)}$ - Output$_{2-(b)}$) terms. For example, the circuit operation of 1-(a) may be followed by the circuit operation of 2-(a), or the circuit operation of 1-(b) may be followed by the circuit operation of 2-(b).

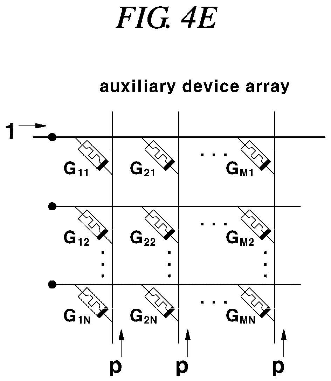

Referring to FIG. 4E, the column of the core cell array at the same position as the column selected in the auxiliary device array is updated in proportion to p. If p>0, it is potentiation, and if p<0, it is depression. For example, in FIG. 4d, the weights of the elements ($G_{11}$, $G_{21}$,...,$G_{M1}$) of the first column of the core cell array may be updated by an amount proportional to p. The p may be a value obtained through the circuit operation disclosed in FIG. 4D. When the core device array and the auxiliary device array are completely updated for the first column, the above-described FIGS. 4A to 4E may be repeated for the second to N columns.

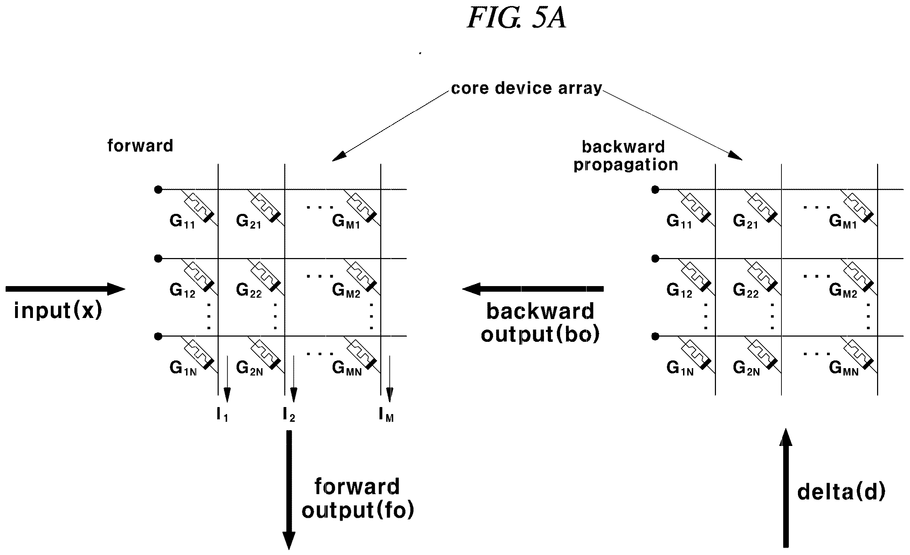

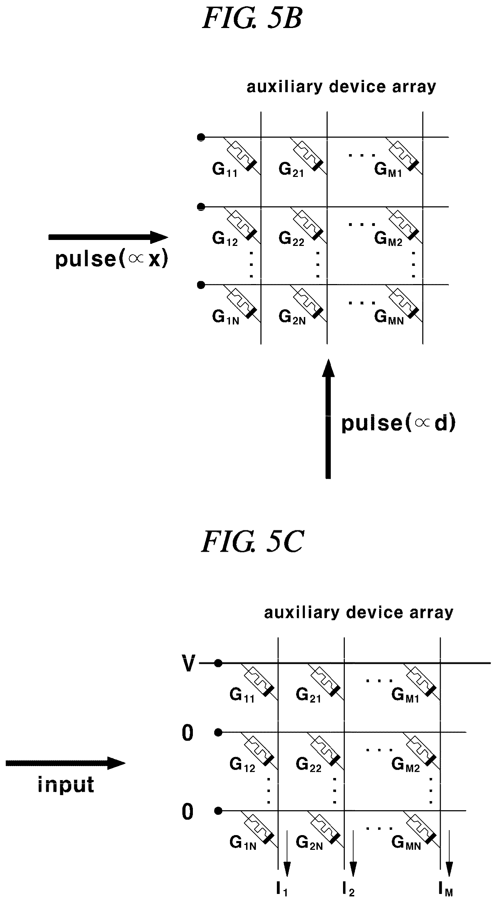

FIG. 5A to FIG. 5F are diagrams for explaining a learning method of a core device using a synapse device 6T1C having non-linear characteristics of the present invention. Since FIGS. 5A to 5C are the same as FIGS. 4A to 4C, the descriptions of FIGS. 4A to 4C may be referred to unless there is a contradiction.

In the case of the aforementioned reference read, leakage converging conductance is read. Thus, if the device is nonlinear, an unintended force that changes the conductance to symmetry conductance may occur as the update progresses. Due to these unintended forces internal to the device, the device may not be set to the desired conductance, which may result in deterioration in accuracy. Therefore, accuracy deterioration occurs because the leakage convergence conductance and the symmetric conductance are not the same, and the directionality difference between the leakage convergence conductance and the symmetric conductance may be offset through a stochastic invert operation for the directionality in which the conductance changes into symmetry conductance rather than converging the leakage convergence conductance and the symmetric conductance to 0.

Specifically, when the device itself has symmetric conductance (weight > 0) > leakage convergence conductance (conductance corresponding weight = 0), an unintended tendency for the weight to increase in the positive direction appears as the update progresses. However, the symmetric conductance may have_weight <0 through the invert process of the present invention, thereby cancelling out the directionality of periodic unintended weight change.

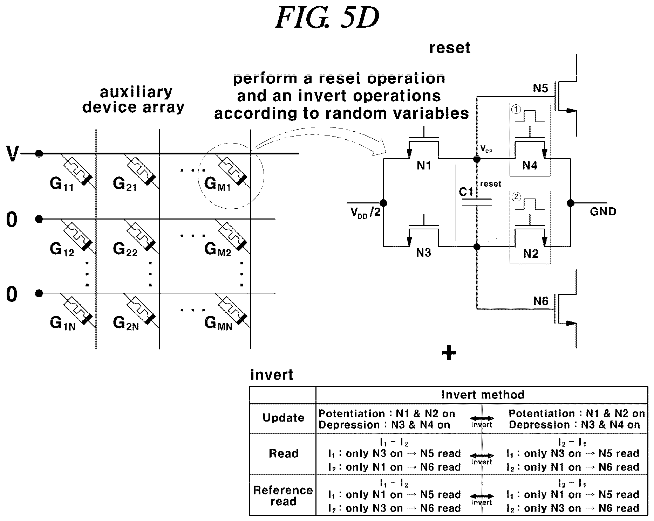

In one embodiment, a probability may be calculated by generating a random number and using the generated random number, and a reset operation or an invert operation is performed based on the calculated probability. FIG. 5D may or may not be selectively performed based on probability.

Since the reset operation of FIG. 5D is the same as the reset operation of FIG. 3G described above, the description of the reset operation of FIG. 3G may be referred to unless there is a contradiction. Additionally, since the invert operation in FIG. 5D is the same as the invert operation in Table 1 described above, the description of the reset operation in [Table 1] above may be referred to unless there is a contradiction.

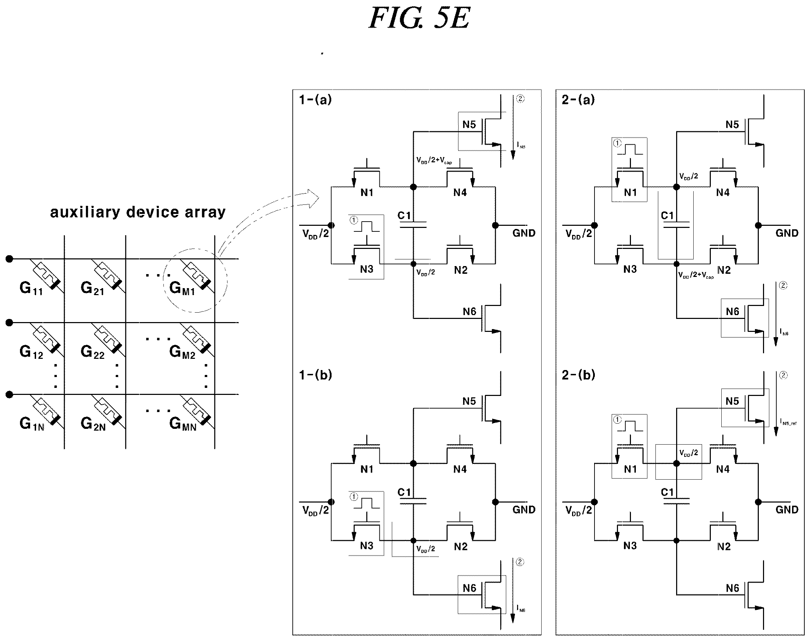

Afterwards, since FIG. 5E is the same as FIG. 4D in which the output current is converted to p through a read operation and a reference read operation, the description of the reset operation in FIG. 4D may be referred to unless there is a contradiction.

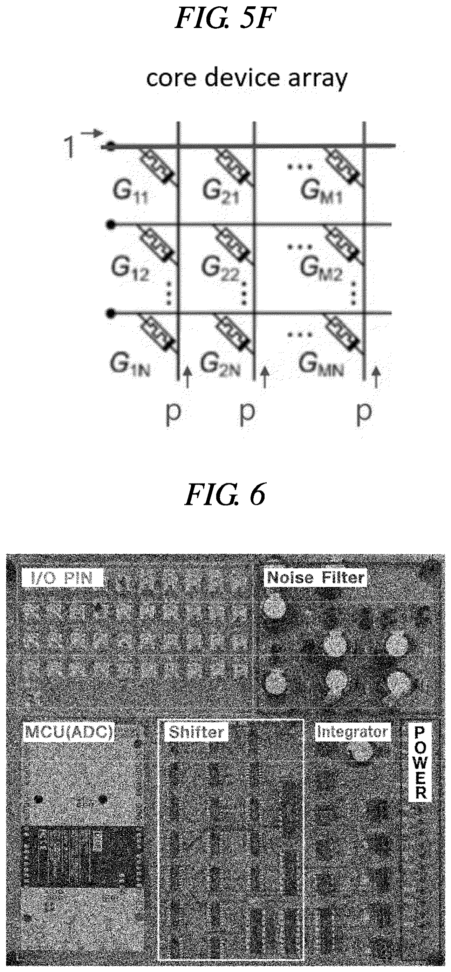

Afterwards, since FIG. 5F is the same as FIG. 4E in which the output current is converted to p through a read operation and a reference read operation, the description of the core device array update in FIG. 4E may be referred to unless there is a contradiction.

In another embodiment, the reset or invert operation of FIG. 5D may be performed after FIG. 5F or while updating the core device array (FIG. 5F).

Conventionally, one neural network consists of a core device array and an auxiliary device array having the same dimension. Here, the conductance of the reference device must be initialized by the linear conductance (symmetry conductance) of the auxiliary device, and the auxiliary device itself must be initialized by the symmetry conductance. Therefore, an additional reference device array is essential. In addition, in the related art, there is an inconvenience that the pulses which increase the conductance and the pulses which decrease the conductance have to be alternately applied to all auxiliary devices in order to initialize the symmetrical conductance.

However, the following features may be achieved by using the device having the proposed 6T1C structure of the present invention and a driving algorithm including the weight update operation (potentiation, depression), read operation, reference read operation, invert operation, and reset operation of the device, thereby solving conventional problems.

First of all, when using the synapse device 100 of the present invention in a linear learning algorithm and a non-linear learning algorithm, the weight accumulated in the capacitor-based device having leakage may be efficiently transmitted to non-volatile memory. Since leakage converging conductance may be read without the reference device array which is essential for auxiliary device arrays by taking advantage of the 6T1C device, improved integration may be expected.

In addition, the more non-linear the device is, the more it receives the force toward symmetry conductance as it repeats the update. Therefore, conventionally, the reference conductance is set to symmetry conductance and the corresponding force is set to weight = 0 (weight = conductance -ref conductance (symmetry conductance)). However, in the case of the 6T1C device of the present invention, there may be factors which change conductance due to retention problems as well as asymmetry. If the 6T1C device is very linear, as the force of symmetry conductance due to asymmetry is weak, the leakage converging conductance may be read as a reference so that the conductance change due to retention may be set as weight = 0. In addition, in the case of leakage converging conductance, that is, when $V_{cap}$=0 (ideally: N1 and N3 transistor characteristics are the same, and N2 and N4 transistor characteristics are the same), the amount of $V_{cap}$ change due to potentiation and the amount of the $V_{cap}$ change due to depression are the same. Therefore, a leakage converging conductance may become a symmetry conductance. Since the expected values are the same to some extent, the reference conductance is set by using the method proposed in the present invention. If the asymmetry of the device is large, invert process may be proceeded in order to compensate for incorrect learning of the core device due to the difference between symmetry conductance and leakage converging conductance. Because of this, it has robust characteristics with respect to retention time and may improve accuracy deterioration due to leakage.

Additionally, in the case of linear learning, accuracy deterioration due to asymmetry rarely occurs.

In addition, in the case of non-linear learning, inverting may be done stochastically to improve accuracy degradation due to asymmetry, and additionally, the asymmetry of the transistor in the synapse device 100 having a 6T1C structure may also be compensated. In addition, the more non-linear a device is, the more it is possible to prevent the weight value expressed by the device from becoming too large or too small, and the more non-linear it is, the more it may be affected by symmetry conductance as updates are repeated.

## Experimental measurement setup and various properties of single synapse device

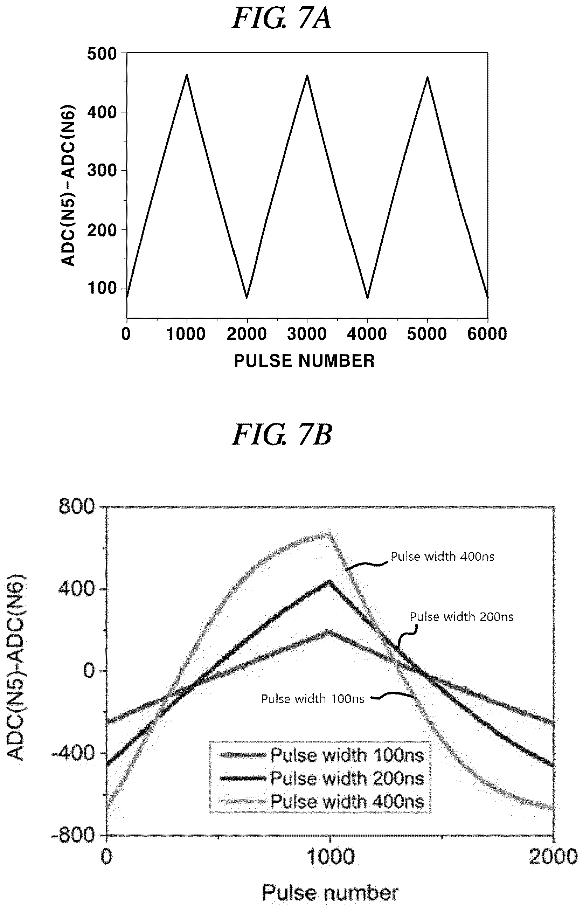

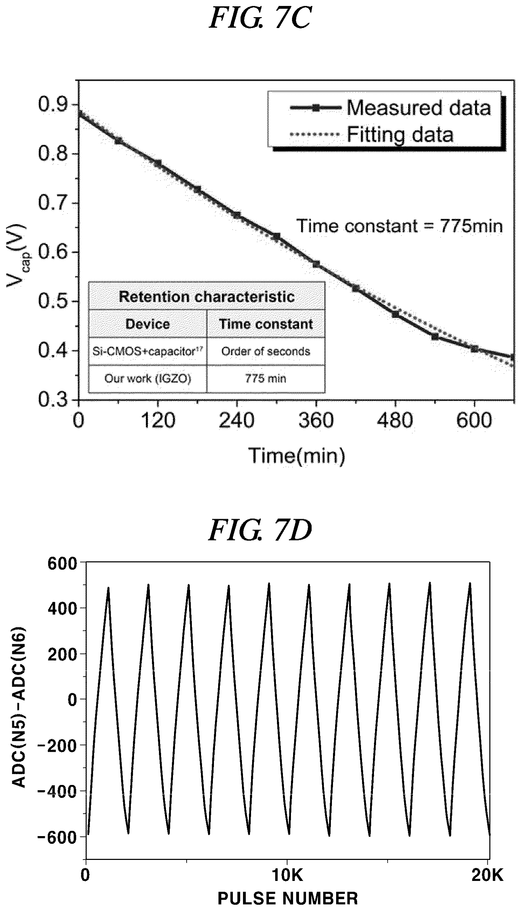

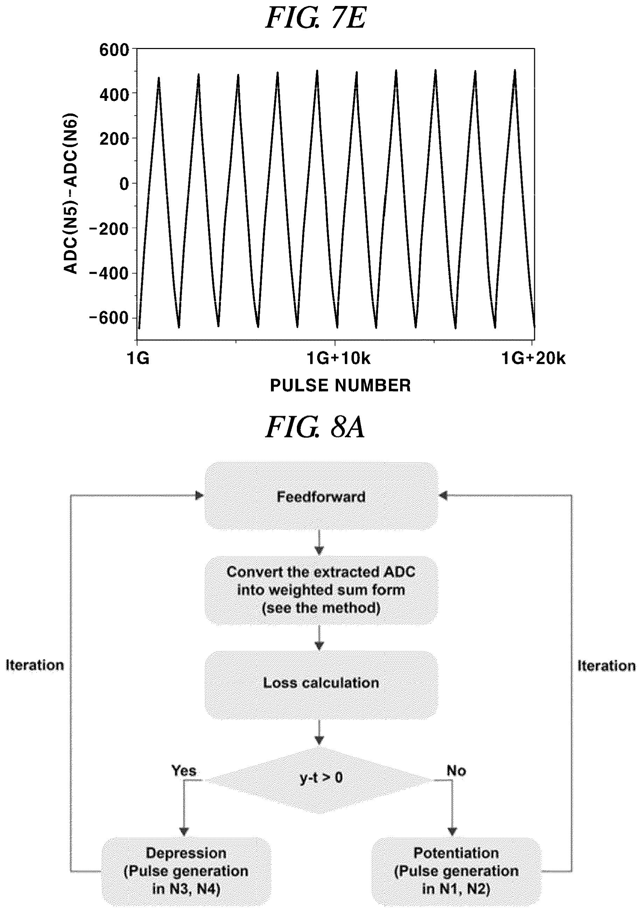

FIG. 6 is an image of a printed circuit board PCB for measuring synapse devices in an embodiment of the present invention. FIG. 7A is a graph of the weight update results of a single synapse device having a 6T1C structure according to an embodiment of the present invention. FIG. 7B is a diagram showing a weight update curve according to an embodiment of the present invention. FIG. 7C is a graph showing the retention characteristic results of a single synapse device having a 6T1C structure according to an embodiment of the present invention. FIG. 7D is a graph showing measurement results in an initial cycle for measuring cycling durability of a single synapse device having a 6T1C structure according to an embodiment of the present invention. FIG. 7e is a graph of measurement results obtained by applying $10^9$ update pulses to a single synapse device having a 6T1C structure according to an embodiment of the present invention.

Referring to FIG. 6, in order to measure various characteristics of a single synapse device, a printed circuit board PCB which combines a microcontroller unit (MCU) with individual integrated circuit components (e.g., shifter, integrator, noise filter, I/O PIN, power module) to interact with the synapse cell array was used. The shifter, integrator, and noise filter may be composed of conventionally disclosed IC chips or components, and detailed description of the PCB circuit will be omitted. The synapse cell current may be measured by a current integrator and MCU (ADC) on the PCB.

Referring to FIG. 7A, the first voltage (=$V_{dd}$/2)) of the single synapse device is supplied at 2.0V, and the overdrive voltage (=$V_{ov}$ defined as = $V_{gs}$-$V_{th}$), the results were obtained by applying 1,000 up/down pulses having a magnitude of 0.25V and a pulse width of 300 ns to the second control transistor N2 and the fourth control transistor N4. Referring to FIG. 7B, the result was obtained when the first voltage (=$V_{dd}$/2) is supplied at 1.5, an overdrive voltage ($V_{ov}$ = $V_{gs}$-$V_{th}$) is 1,000 up/down pulses having 1.4V are applied to the second control transistor N2 and the second control transistor N2.

FIG. 7A and FIG. 7B show the weight update characteristics of a single synapse device having a 6T1C structure measured by using the PCB circuit disclosed in FIG. 6. FIG. 7A shows the measured ADC change of a single cell by applying 4 cycles of 1,000 positive updates and 1,000 negative updates. In order to maintain improved linearity and symmetry of the synapse device, the second control transistor N2 and the fourth control transistor N4 must be allowed to reach the saturation region. For this purpose, an overdrive voltage ($V_{ov}$ = $V_{gs}$-$V_{th}$) lower than the first voltage (=$V_{dd}$/2) may be applied to the second control transistor N2 and the fourth control transistor N4 and a high voltage may be applied to the first voltage (=$V_{dd}$/2). Referring to FIG. 7B, it shows conductance modulation according to voltage pulses of 100ns, 200ns, and 400ns, respectively. Referring to FIG. 7A and FIG. 7B, the synapse device having the 6T1C structure exhibits highly linear and symmetric weight update characteristics in 1,000 conductance states, and the conductance modulation of the device may be accurately controlled by changing the measurement conditions in the same device.

Referring to FIG. 7C, the retention characteristics were measured by applying an off voltage of -2V to each control transistor (N1-N4). First, in order to evaluate the retention characteristics of the device, after capacitor C1 was intentionally charged by repeatedly applying reinforcing pulses to the synapse cell, and then applying off-voltage to all control transistors (N1-N4), read operation were performed at fixed time intervals (60 minutes). After converting the measured ADC to a capacitor voltage, exponential fitting was performed to extract the time constant, resulting in approximately 775 minutes. These results show that the 6T1C structured synapse device exhibits very excellent retention characteristics as compared to existing silicon and capacitor-based synapse devices.

Referring to FIGS. 7D and 7E, these are measurement results after applying $10^9$ update pulses (the height of the update pulse is 0.5V/-2V, the length is $1\mu s$). Update pulse $10^9$ was applied to the synapse device by repeating 1,000 up/1,000 down pulses 500,000 times. When comparing the output ADC of the initial cycle and the last cycle shown in FIG. 7D and FIG. 7E, respectively, it was confirmed that the device was still operating and the output range of the ADC was almost unchanged even after $10^9$ pulses were applied. As a result of confirmation process, it may be confirmed that the synapse device having the 6T1C structure not only endures for a long time, but also exhibits stable analog characteristics over many cycles.

### Experimental results of linear regression based on stochastic update method on 5X1 6T1C array.

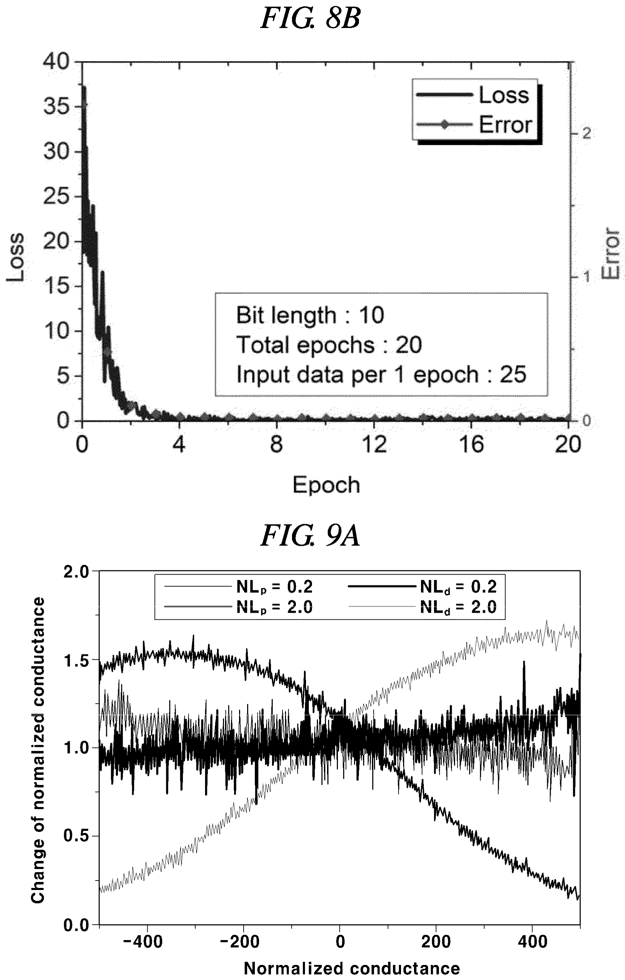

FIG. 8A is a flowchart for linear regression training according to an embodiment of the present invention, and FIG. 8B is a graph of evaluation results of loss and error throughout training according to an embodiment of the present invention.

Referring to FIG. 8a, training consists of two stages: feedforward and weight update (potentiation, depression), and the loss is defined as $\dfrac{1}{2}(y-t)^2$ by using the mean square error (MSE) function.

Referring to FIG. 8B, as training progresses, both of loss and error may converge to 0. 25 input data sets are trained at each epoch (input data per 1 epoch). The total epochs are 20, the bit length is set to 10 during the demo and the learning rate is 0.05. The error in FIG. 8b is defined as $\displaystyle\sum_{n=1}^{5}(w_n - t_n)^2$ .

### Implementing linear regression on crossbar array

Linear regression was experimentally performed by using 6TIC 5X1 crossbar array to evaluate the on-chip training performance of the synapse device. The training process used the flowchart of FIG. 8a, and the input data in the feedforward process and the stochastic update pulse in the weight update process were generated in real time through the MCU located on the PCB. First, an input dataset for the feedforward process was created and applied to the word lines WL of each of the five synapse devices as a form of a pulse width. The input data matrix consists of four randomly generated data and one fixed value which serves as the y-intercept in a form of $x_i = [x_1, x_2, x_3, x_4, a]$. When the feedforward process is performed, the y value of [Equation 3] below is generated.

$$[\text{Equation 3}]$$

$$y = x_i[w_1, w_2, w_3, w_4, w_5]^T$$

Here, xi represents the input data matrix and $[w_1, w_2, w_3, w_4, w_5]$ represents the weight matrix. Next, Y may be compared with the target value t in [Equation 4a] to generate an error vector $\delta_i$ $\delta_i$ in [Equation 4b].

$$[\text{Equation 4a}]$$

$$t = x_i[t_1, t_2, t_3, t_4, t_5]^T$$

$$[\text{Equation 4b}]$$

$$\delta_i = x_i[w_1, w_2, w_3, w_4, w_5]^T - t$$

Here, $[t_1, t_2, t_3, t_4, t_5]$ represents the target weight matrix. The process for converting the output ADC values to a weighted sum and the loss calculation process are performed by the MCU located on the PCB. Weight update is performed by using the following probabilistic update technique. The weight update amount of each synapse cell follows [Equation 5a] and [Equation 5b] below.

[Equation 5a]

$$\Delta w_n = -\eta x_n \delta_i (n = 1 \sim 4) \quad (5a)$$

[Equation 5b]

$$\Delta w_n = -\eta a \delta_i \quad (5b)$$

Here, $x_n$ and a represent the input data applied to each synapse cell, $\delta_i$ represents the error extracted through feedforward, and $\eta$ represents the learning rate. In the weight update process, $x_n$ and a were converted to the pulse occurrence probability of the first control transistor N1 or the third control transistor N3, and $\delta_i$ was converted to the pulse occurrence probability of the second control transistor N2 or the fourth control transistor N4. As shown in FIG. 8A, the sign of (y-t) will determine whether to generate pulses for potentiation or depression. We may train the 6T1C 5X1 crossbar array and solve the linear regression problem by repeating this procedure. FIG. 8b shows that loss and error converge to 0 as learning progresses. These linear regression results demonstrate the automatic and parallel on-chip training capabilities of the 6T1C array.

**Pattern recognition simulation using 6T1C device**

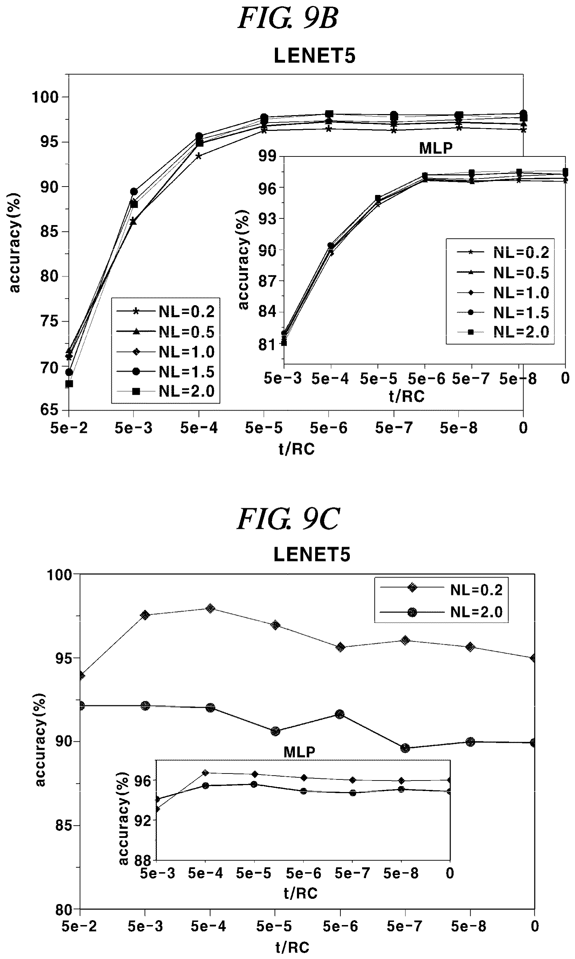

FIG. 9A is a result graph of conductance-conductance change type obtained under various measurement conditions according to an embodiment of the present invention. FIG. 9B is a graph showing the accuracy of the device according to retention characteristics by applying the conventional Tiki-taka algorithm after reflecting various values within the NL range of the synapse device having a 6T1C structure according to an embodiment of the present invention. FIG. 9C is a graph showing the accuracy of the device according to the retention characteristics obtained by applying the proposed invention at NL=0.2 and NL=2.0 according to an embodiment of the present invention. In the following description, 'NL' is a parameter representing linearity and non-linearity, '$NL_p$' represents the direction in which conductance increases, i.e., linearity and non-linearity in the potentiation operation, and '$NL_d$' represents the direction in which conductance decreases, i.e., exhibiting linearity and nonlinearity in the depression operation. Specifically, the closer the 'NL' value is to 0, the more linear it is, and the closer the 'NL' value is to 2, the more non-linear it is. LENET5 refers to the structure of the CNN neural network contained in Yann LeCun's paper 'Gradient-Based Learning Applied to Document Recognition' in 1998, and multi-layer perceptron (MLP) refers to a multi-layer neural network structure model in which several perceptron neurons are stacked in multiple layers

Referring to FIG. 9A, the graphs of NL = 0.2 and NL = 2.0 are the results obtained by converting the red and green lines of FIG. 7A and FIG. 7B, respectively. When NL = 2.0, linear regression analysis was used only for some areas used for learning.

Referring to FIG. 9B, when using the conventional Tiki-taka algorithm, the accuracy decreases as the retention time (t/RC) applied to the retention characteristic becomes smaller. This is because, in the case of conventional capacitor-based devices, leakage occurs due to leakage converging conductance.

In addition, in the conventional case, when the neural network required for learning becomes large, a reference array for auxiliary learning is required, and the area occupied by this reference array increases, which causes a problem that the degree of integration deteriorates. Additionally, as learning progresses, the characteristics of the device may change and the symmetry conductance may change. The symmetrical conductance is the conductance per pulse applied to each device, and is a conductance value for which an increase amount and a decrease amount are same.

Referring to FIG. 9C, in the case of a synapse device having a 6T1C structure according to the present invention, unlike the conventional case of FIG. 7B, it may be seen that the neural network training results, that is, the learning accuracy results, are approximately 97% or more even for a small retention time (t/RC) when setting a leakage converging conductance as a reference in a linear environment (NL=0.2). In other words, an accuracy of about 97% was achieved when using the optimized learning rate (linear learning) for learning at $5e^{-2}$ for the LENET5 model and $5e^{-3}$ for the MLP model. However, when asymmetry is large, the force toward symmetric conductance is strong, which means that optimal accuracy may not be obtained simply by setting the reference to leakage converging conductance.

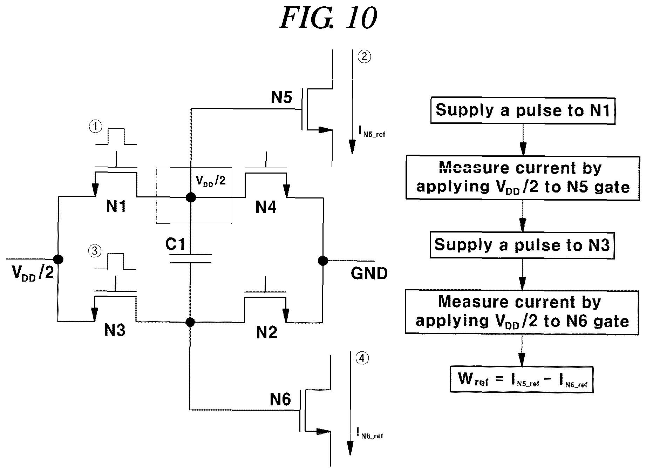

FIG. 10 is a diagram for explaining a method for setting reference conductance according to an embodiment of the present invention. The reference conductance refers to the conductance when $V_{cap} = 0$ described above.

Referring to FIG. 10, the reference conductance is read (⑤) as the difference between the current $I_{N5}$ (②) of the first output transistor N5 to which a pulse is applied (①) to the first control transistor N1, and the current $I_{N6}$ (④) of the second output transistor N6 to which the pulse is applied (③) to the third control transistor N3. Specifically, after applying a pulse $V_{DD}/2$ to the first control transistor N1 (①), the current $I_{N5}$ flowing through the first output transistor N5 is measured (②). Next, after applying a pulse to the third control transistor N3 (③), the current $I_{N6}$ flowing through the second output transistor N6 is measured (④). Afterwards, the difference between current $I_{N5}$ and current $I_{N6}$ is calculated (⑤).

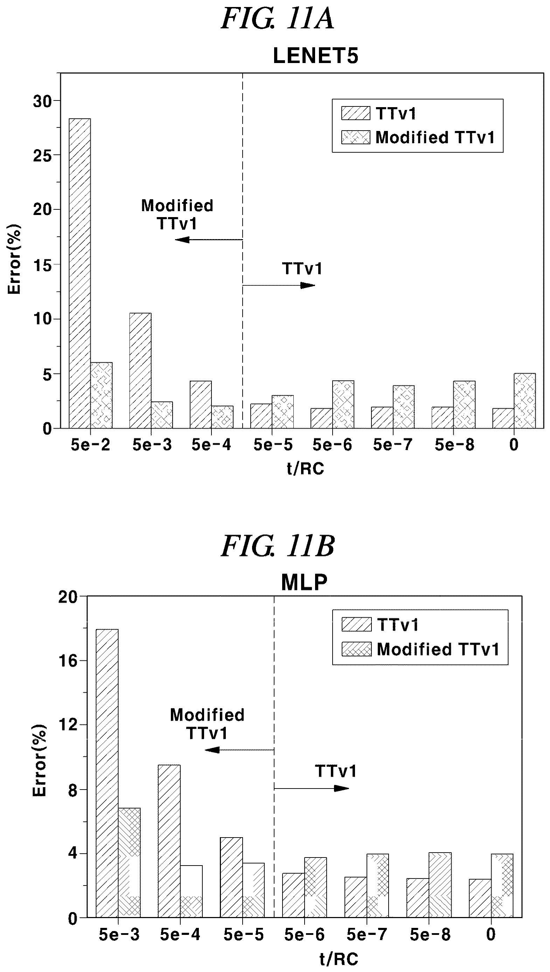

FIG. 11A and FIG. 11B are result graphs obtained by comparing the learning results according to the linear learning method of the present invention and the conventional method at various retention levels in the LENET5 model and the MLP model, respectively. The linear learning method of the present invention (referred to as Proposed Invention 1 (Modified TTv1)) refers to learning performed through the reference read operation described above, and it refers to learning performed through the TTv1 algorithm for linear or non-linear learning.

Referring to FIG. 11A, in the case of the LENET5 model, when the proposed invention (red) is applied at $5e^{-4}$ or lower, the error rate is lower than when the conventional Tiki-taka algorithm (black) is applied, but when the proposed invention is applied at $5e^{-5}$ or higher, the error rate is higher than when applying the conventional Tiki-taka algorithm.

Referring to FIG. 11b, similar to FIG. 9a, in the case of the MLP model, when the proposed invention (red) is applied at $5e^{-5}$ or less, the error rate is lower than when the conventional Tiki-taka algorithm (black) is applied, but when applying the proposed invention at $5e^{-6}$ or more, the error rate is higher than when applying the conventional Tiki-taka algorithm.

As described above, in the case of linear learning, the error rate may be improved by performing the algorithm of proposed invention 1 (Modified TTv1) based on a specific threshold, and performing the conventional TTv1 algorithm after the specific threshold.

In another embodiment, an effect that the error rate for the entire section may be obtained when using an algorithm (e.g., referred to as a proposed invention 2) which performs the reference read operation, reset operation, and invert operation described above for linear or nonlinear learning.

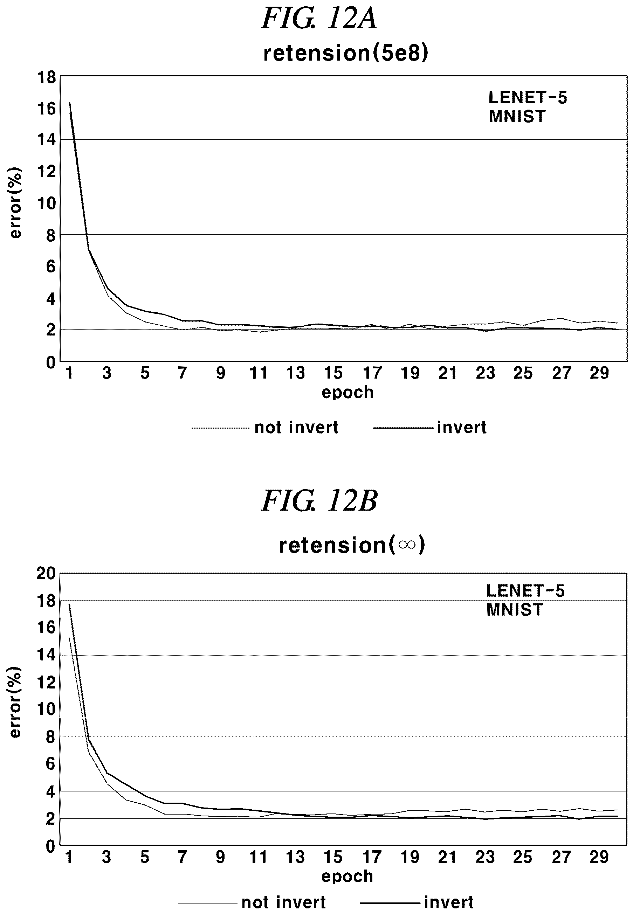

FIG. 12A and FIG. 12B are result graphs comparing non-linear learning results when invert and reset operations are performed and when they are not performed in the LENET5 model. FIG. 12A shows the results of an experiment when the retention value is set to $5e^8$, and FIG. 12B shows the results of an experiment when the retention value is set to infinite. The x-axis (epoch) is the number of learning iterations. The red line is the case to which the algorithm of proposed invention 2 is applied when the above-mentioned invert and reset operations are applied, and the black line is a case to which the algorithm of proposed invention 1 is applied without applying the above-described invert and reset operations applied.

Referring to FIG. 12A and 12B, it may be seen that in Proposed Invention 1 (black), as non-linear learning is repeated, the learning degree deteriorates and the error rate increases, but in Proposed Invention 2 (red), the learning degree deterioration improves as non-linear learning is repeated, and the error rate decreases. As mentioned earlier, when the device itself has symmetric conductance (weight > 0) > leakage convergence conductance (conductance representing weight = 0), as the update progresses, there may be an unintended tendency for the weight to increase in the positive direction, which may deteriorate accuracy. But, it is believed that the symmetric conductance may represent weight <0 through the invert process of the present invention, and thus periodically cancel out the direction of unintended weight change, thereby improving the deterioration.

In another embodiment, at the beginning of nonlinear learning (approximately in the range of 0 < epoch < 18), the error rate of proposed invention 1 (black) is relatively lower than that of proposed invention 2 (red). Thus, in the early stages of learning, learning is performed according to proposed invention 1 and then, after the threshold, if you proceed with Proposed Invention 2, the error rate may be lowered compared to when nonlinear learning is performed only with Proposed Invention 2.

## Algorithm optimized for synapse devices having 6T1C structure

Improving the performance of AiMC systems needs to consider both of algorithm level and hardware level approaches. The present invention aims to improve optimization through hardware-algorithm co-design. Simulation was performed by applying the conventional SGD algorithm and TTv1 (Tiki-Taka algorithm) to the device of the present invention. The simulation results of the present invention show that the present invention is suitable for TTv1 as well as SGD algorithm. Additionally, the present invention proposes a driving algorithm for a synapse device having a 6T1C structure which is a device which exceeds the performance of TTv1.

The powerful driving algorithm of the present invention 1) does not decrease learning accuracy even when the retention level required for learning increases, and 2) allows the reference conductance to be easily set in the device itself without a separate reference cell array.

First of all, the present invention simulated neural network training by using the SGD algorithm based on the weight update characteristics and retention time from the measurement results shown in FIG. 7B and FIG. 7C. Additionally, the device variations for parameters representing device asymmetry in the 6T1C structure are applied as follows: 15% for NL, 7% for $G_{max}$ and $G_{min}$, 6% for $\Delta w_{min}$, 15% for retention time, and 15% for $G_{leak}$. $G_{max}$ and $G_{min}$ represent the maximum and minimum conductance of the device, respectively. $G_{leak}$ represents the conductance at which a volatile device converges after complete retention failure. For cycle standard deviation, 5% standard deviation was applied to write noise, 6% to current sum, and 30% to $\Delta w_{min}$. The following transformations were applied to all simulations other than the SGD algorithm: Assuming that the training cycle length (Forward + Backward + Update) per layer is 200ns, ~98.5% accuracy was obtained. This result appears to be due to the symmetrical behavior and excellent retention properties of the 6T1C synapse apparatus.

Secondly, the present invention performed neural network training by using a training algorithm (TTv1) designed for a conventional asymmetric analog synapse device. Conventional TTv1 operates completely in parallel and trains the core device through update information performed by the auxiliary device. In this case, a synapse device having a 6T1C structure which has excellent update characteristics but has leakage is used as an auxiliary device, and an ordinary non-volatile memory NVM is used as a core device to periodically transfer the weight of 6T1C to the NVM. This allows reading without weight loss during the inference process. In order to use TTv1 for training, the weight update measurement results of 6T1C were converted into the conductance-conductance change form of FIG. 7A. Afterwards, FIG. 7A was modeled through linear regression, and simulation parameters were extracted from [Equation 6a] and [Equation 6b] below.

[Equation 6a]

$$\Delta G_p = \left( 1 - NL_P \times \frac{G - G_{sym}}{G_{max} - G_{min}} \right) \times \Delta G_{sym}$$

[Equation 6b]

$$\Delta G_d = \left( 1 - NL_d \times \frac{G - G_{sym}}{G_{max} - G_{min}} \right) \times \Delta G_{sym}$$

Here, $\Delta G_p$, and $\Delta G_d$ represent the conductance change of one potentiation and depression pulse, respectively. $G_{sym}$ represents the symmetrical conductance that satisfies $\Delta G_p = \Delta G_d$. As shown in FIG. 7a, both linear update results (NL ≈0.2) and intentionally asymmetric update results (NL ≈2.0) may be extracted from the same device by changing the measurement conditions. The prior art shows that the NL combination of the core and auxiliary devices is important to achieve optimal learning accuracy using TTv1. In other words, it is important to obtain the target NL value in order to find the optimal combination. However, in the typical resistive switching devices, it is impossible to obtain the target NL value because the conductance modulation mechanism relies on atomic-level random processes. On the other hand, as shown in FIG. 7A, a device having the 6T1C structure of the present invention may have a wide range between NL=0.2 and 2 by changing the measurement conditions in the same device, and the target NL value may be easily obtained based on clear conductance modulation.

FIG. 7B shows the results obtained by applying TTv1 under the same core device conditions by reflecting various values within the NL range of the 6T1C structure device. Similar to previous conventional results, learning accuracy changed depending on the NL of the 6T1C structured device. However, since the device of the present invention may easily obtain the target NL value by changing the measurement conditions, optimal learning accuracy may be achieved through TTv1 regardless of the type of core device.

Additionally, if TTv1 for 6T1C devices is used, weight transfer may also be performed. Despite the good retention characteristics of devices having the 6T1C structure, a weight transfer process which transfers the stored weights to the NVM is essential due to long-term retention loss. However, the weight transfer technique requires serial access to the intersection elements one by one or row by row. Pure weight propagation may cause enormous overhead in large networks because it involves time-consuming serial operations, repetitive programming and weight verification. On the other hand, if TTv1 is used, learning and weight transfer may be performed simultaneously and completely in parallel.

Although the device having the 6T1C structure has been proven to be suitable for the conventional TTv1, learning accuracy may decrease as the time required for learning increases, as shown in FIG. 7B. Therefore, the driving algorithm of the present invention is used to restore learning accuracy even when longer retention is required. First of all, we analyzed the phenomenon of accuracy deterioration depending on the retention level in the conventional TTv1.

When performing TTv1 using a volatile device as an auxiliary device and a non-volatile device as a core device, the weight updates of the auxiliary device and the core device follow [Equation 7a] and [Equation 7b], respectively.

[Equation 7a]

$$\dot{A} = -\left( 1 - e^{-\frac{t_{update}}{RC}} \right)(A - A_{leak}) - \eta_A e^{-\frac{t_{update}}{RC}}\left( \left( \frac{\partial E}{\partial C} + \varepsilon(t) \right) + NL_A \frac{A - A_{sym}}{A_{max} - A_{min}} \left| \frac{\partial E}{\partial C} + \varepsilon(t) \right| \right) \quad (7a)$$

[Equation 7b]

$$\dot{C} = \eta_C (A - A_{ref}) - \eta_C |A - A_{ref}| NL_C \frac{C - C_{sym}}{C_{max} - C_{min}} \quad (7b)$$

Here, $t_{update}$ represents the training cycle length per layer of the auxiliary array, and $\varepsilon(t)$ represents the stochastic effect which occurs during update. $\eta_A$ and $\eta_C$ are the learning rates of the auxiliary and core devices, respectively. E represents the cost function.

Then, the weights of the auxiliary device and the core device must satisfy [Equation 8a] and [Equation 8b], respectively, to reach the steady state. In TTv1 using NVM, $A_{ref}$ is set to $A_{sym}$ and after sufficient learning, $|A - Asym = 0|$ condition may be satisfied. Thus, the global minimum may be reached. However, when a volatile device is used as an auxiliary device, since the right side of [Equation 8a] does not converge to 0, the global minimum may not be reached. As a result, as the maintenance time required for training increased, learning accuracy decreased, as shown in FIG. 7B.

[Equation 8a]

$$\left\langle \frac{\partial E}{\partial C} \right\rangle = -\frac{NL_A}{A_{max} - A_{min}} \left| \frac{\partial E}{\partial C} + \varepsilon(t) \right| (A - A_{sym}) - \eta_A^{-1} \left( e^{\frac{t_{update}}{RC}} - 1 \right) (A - A_{leak}) \quad (8a)$$

[Equation 8b]

$$\langle A \rangle - A_{ref} = NL_C \frac{C - C_{sym}}{C_{max} - C_{min}} |(A - A_{ref})| \quad (8b)$$

However, the decrease in accuracy due to retention may be solved by the driving algorithm (modified TTv1) of the device of the present invention, which sets $A_{ref}$ to $A_{leak}$. Due to the device having the 6T1C structure, the expected values of $A_{sym}$ and $A_{leak}$ are the same when $V_{cap}=0$, and in the device having the 6T1C structure, it is possible to perform highly linear weight updates as shown in FIG. 7A. Therefore, the influence of the term related to asymmetry which is the first term on the right side of [Equation 8a], may be almost ignored, and if $A_{ref}$ is set to $A_{leak}$, it may be expected to reach the global minimum.

When the global minimum is reached, the asymmetry effect further decreases as the size of $\left| \frac{\partial E}{\partial C} + \varepsilon(t) \right|$ of

[Equation 8a] becomes smaller. FIG. 7C shows the neural network training results obtained by applying modified TTv1 to NL=0.2, 2.0. In the highly linear case with NL=0.2, an accuracy of ~97.5% may be achieved even though the required retention time increases. In addition, as analyzed in [Equation 7a] above, it was confirmed that the accuracy decreases as the asymmetry of the device increases.

The modified TTv1 of the present invention also has the advantage of being able to quickly and easily set the reference conductance in a 6T1C structure device without a separate reference cell array. It is known that it is important to set an accurate and stable reference conductance for a symmetric conductance in conventional TTv1, but the conventional symmetric conductance setting method is relatively complicated and requires additional arrangement. However, the device having the 6T1C structure of the present invention may quickly and accurately retrieve the reference conductance by performing one more read operation (refer to FIG. 7D). Additionally, if the characteristics of the device change during training, the symmetrical conductance of the device itself or the conductance of the reference device may change and thus, accuracy may be reduced. However, in the case of the modified TTv1 of the present invention, the reference conductance may be read stably even if the characteristics of the device change during training.

Referring again to FIGS. 9A and 9B, the learning results obtained by applying conventional TTv1 and modified TTv1 at various retention levels are shown. As may be seen in [Equation 8a], the retention characteristics and asymmetry of the device have a complex effect on learning accuracy, and the algorithm required for optimal learning may change depending on the retention level. However, if a device having a 6T1C structure is used, it is possible to flexibly select the algorithm depending on the retention level. If the retention features required for learning increase due to complex datasets or neural networks, optimal accuracy may be achieved by applying modified TTv1 using a highly linear update condition. If the retention characteristics of the device are sufficient for learning, optimal accuracy may be obtained by applying TTv1, which uses update conditions appropriate for the asymmetry of the core device.

Additionally, scalability, a drawback of capacitor-based synapse, may be improved through a device having a 6T1C structure and an optimized algorithm. As the size of the capacitor gets smaller, it is difficult to secure sufficient retention time for learning, which limits the scalability of capacitor-based synapse devices. For example, it is known that CNN (Convolutional Neural Network) requires a capacitance of 100fF/a large capacitance of a cell. The size may be reduced, thereby increasing device expandability. For example, if IGZO TFTs and capacitors at the current lowest current levels are applied, high learning accuracy may be achieved by training large input data with a synapse of 10fF capacitance/cell. Therefore, a device having a 6T1C structure may be used as a versatile and practical synapse device which may be applied to large amounts of input data and complex neural networks.

As described above, in order to solve the maintenance problem of the capacitor-based charge storage synapse, the present invention proposes a synapse device consisting of an IGZO TFT having a low leakage current, one capacitor, and six transistors. We demonstrated that our device may provide sufficient retention time and parallel on-chip training operations as well as linear and symmetric weight updates by manufacturing a single synapse device and 5X5 crossbar array. We also demonstrate the importance of device-algorithm co-optimization by developing an efficient yet realistic training algorithm to compensate for remaining device non-idealities such as drifting references and long-term retention loss.

Additionally, an algorithm of the present invention does not require a separate reference cell array and may reach a high learning accuracy of ~97% even though the retention time required for training increases. Thus, smaller synapse array size may be implemented by using smaller capacitors. It is expected that the size of the 6T1C device may be further reduced by conventional ultralow-leakage, nano-sized IGZO TFTs and capacitors. Device footprint may be further improved through Monolithic 3D (M3D) integration and IGZO atomic layer deposition (ALD) based vertical channel thin-film transistor (VTFT). Therefore, the 6T1C device of the present invention may be said to be a practical synapse device for neuromorphic computing.

In this specification, the preferred embodiments of the present invention have been disclosed, and although specific terms have been used, they are only used in a general sense to easily explain the technological content of the present invention and to help understanding the present invention, and they are not used to limit the scope of the present invention. It is obvious to those having ordinary skill in the related art to which the present invention belong that other modifications based on the technological idea of the present invention may be implemented in addition to the embodiments disclosed herein. It will be understood to those having ordinary skill in the related art that in connection with a synapse device of a charge storage type for deep neural network training according to the embodiment described with reference to FIGS. 1A to 12B and driving method thereof, various substitutions, changes, and modifications may be made without departing from the technological spirit of the present invention. Therefore, the scope of the invention should not be determined by the described embodiments, but should be determined by the technological concepts described in the claims.

The present invention relates to a synapse device of a charge storage type for deep neural network training and a driving method thereof, and has industrial applicability.

**Claims**

1. A synapse device of a charge storage type comprising:

   a weight capacitor having a first terminal and a second terminal and storing a voltage corresponding to the weight;
   four control transistors which change a voltage or a weight of the capacitor;
   a first output transistor including a first gate terminal coupled to the first terminal of the capacitor, and outputting a first drain current according to a voltage applied to the first gate terminal;
   and a second output transistor including a second gate terminal coupled to the second terminal of the capacitor, and outputting a second drain current according to the voltage applied to the second gate terminal, and
   wherein the weight is read as the difference between the first drain current and the second drain current.

2. The synapse device of a charge storage type of the claim 1, wherein

   each of the first control transistor and the third transistor of the four control transistors may have a first source terminal and include a pass transistor which transmits a first voltage connected to the first source terminal to the weight capacitor,
   each of the second control transistor and the fourth transistor of the four control transistors has a second source terminal and include a transistor which functions as a current source based on a ground connected to the second source terminal,

each of the first control transistor and the fourth transistor includes a first drain terminal, the first drain terminals are connected to each other and to the first terminal of the weight capacitor, and

each of the second control transistor and the third transistor includes a second drain terminal, and the second drain terminals are be connected to each other and to the second terminal of the weight capacitor.

3. The synapse device of a charge storage type of the claim 2, wherein

the first control transistor is connected between the first voltage and the first terminal of the weighting capacitor, and connect the first voltage and the first terminal of the weighting capacitor in response to a first control signal,

the second control transistor is connected between the ground and the second terminal of the weight capacitor, and connect the ground and the second terminal in response to a second control signal,

the third control transistor is connected between the first voltage and the second terminal of the weighting capacitor, and connect the first voltage and the second terminal of the weighting capacitor in response to a third control signal,

the fourth control transistor is connected between the ground and the first terminal of the weight capacitor, and connect the ground and the first terminal in response to a fourth control signal,

the first output transistor has a third drain terminal connected to a first input line and a third source terminal connected to the first output line,

the second output transistor has a fourth drain terminal connected to a second input line and a fourth source terminal connected to a second output line,

the first drain current of the first output transistor is determined by the voltage of the first terminal of the weight capacitor, the voltage of the first input line, and the voltage of the first output line, and is supplied to the first output line, and

the second drain current of the second output transistor is determined by the voltage of the second terminal of the weight capacitor, the voltage of the second input line, and the voltage of the second output line, and is supplied to the second output line.

4. The synapse device of a charge storage type of the claim 2, wherein an overdrive voltage which is relatively lower than the first voltage is applied to the second control transistor and the fourth control transistor.

5. The synapse device of a charge storage type of the claim 2, wherein

the weight increases in a positive direction through a potentiation update which operates by turning on the first control transistor and the second control transistor, and

the weight increases in the negative direction through a depression update which operates by turning on the third control transistor and the fourth control transistor.

6. The synapse device of a charge storage type of the claim 5, wherein the weight is determined by the discharge current of the second control transistor or the fourth control transistor, the pulse width applied to the second control transistor or the fourth control transistor, and the capacitance of the weight capacitor.

7. The synapse device of a charge storage type of the claim 2,

the third control transistor reads the first drain current of the first output transistor through a read operation which is turned on,

the first control transistor reads the second drain current of the second output transistor through a read operation in which is turned on, and

the difference between the first drain current and the second drain current is determined as a weight,

8. The synapse device of a charge storage type of the claim 2, wherein

the first control transistor reads the third drain current of the first output transistor through a reference read operation which is turned on,

the third control transistor reads the fourth drain current of the second output transistor through a reference read operation which is turned on,

the difference between the third drain current and the fourth drain current is determined as the reference conductance,

and when the weight capacitor has the reference conductance, the voltage $V_{cap}$ of the weight capacitor is 0.

9. The synapse device of a charge storage type of the claims 5, 7 or 8, wherein an invert operation is performed for at least one of the potentiation update, the depression update, the read operation, and the reference read operation may be inverted.

10. The synapse device of a charge storage type of the claim 2, wherein the voltage $V_{cap}$ of the weight capacitor is reset to 0 by turning on the second control transistor and the fourth control transistor.

11. The synapse device of a charge storage type of the claim 10, wherein the reset operation is performed before the invert operation.

12. The synapse device of a charge storage type of the claim 1, wherein the four control transistors, and the first and the second output transistors are an amorphous InGaZnO FET (Field Effect Transistor), a polycrystalline InGaZnO FET, a single crystalline InGaZnO FET, or a C-axis grown crystal InGaZnO (C-axis aligned InGaZnO) FET.

13. The synapse device of a charge storage type of the claim 1, wherein the nonlinearity of the synapse device is adjusted according to the pulse conditions applied to the four control transistors.

14. A driving method of a synapse device of the disclosed claim 1 wherein reference read operation is performed in the case of linear learning, and performing a reference read operation, a reset operations and an invert operation are performed in the case of non-linear learning.

15. A learning method of a neural network consisting of a core device array including M×N first synapse devices and an auxiliary device array including M×N second synapse devices of disclosed claim 1 comprising:

a first step for generating an output value by applying forward propagation and back propagation methods in the core device array;
a second step for firstly updating the auxiliary device array by applying a pulse corresponding to an output value from the core device array to the auxiliary device array;
a third step for selecting a specific column of the auxiliary device array after the firstly updating, and for generating an output current from the specific column;
a fourth step for converting each of output current into an input value of the core device array by performing a read operation and a reference read operation through the synapse device of each disclosed claim 1 of the specific column; and a fifth step for secondly updating a specific column of the core device array through the input value.

16. The learning method of a neural network of the claim 15, further including a step for performing a reset operation or an invert operation according to a random variable by using the synapse device of disclosed claim 1 of each of specific columns of the auxiliary device array may be further included.

17. The learning method of a neural network of the claim 16, wherein the reset operation or the invert operation is not performed in the case of linear learning, but is performed in the case of non-linear learning.

18. The learning method of a neural network of the claim 16, wherein the reset operation or the invert operation is not performed during the initial learning period but is performed after the initial learning period.

19. The learning method of a neural network of the claim 16, wherein the steps 1 to 5 are repeatedly performed for the remaining columns of the core device array and the auxiliary device array after the fifth step.

## FIG. 1A

*FIG. 1B*

## FIG. 2A

Gate Oxide

Gate W

Source W    IGZO    Drain W

oxide

silicon substrate

## FIG. 2B

capacitor dielectric

upper electrode(W)

lower electrode(W)

oxide

silicon substrate

## FIG. 3A

N5

①

$V_{CP}$

N1    N4

$+V_{cap} = V_{CP} - V_{CN}$

C1    ②

$V_{DD}/2$    GND

N3    N2

$V_{CN}$

N6

## FIG. 3B

## FIG. 3C

# FIG. 3D

# FIG. 3E

## FIG. 3F

## FIG. 3G

# FIG. 4A

EP 4 660 884 A1

## FIG. 4B

auxiliary device array

pulse($\propto$ x)

pulse($\propto$ d)

## FIG. 4C

auxiliary device array

input

FIG. 4D

## FIG. 4E

auxiliary device array

# FIG. 5A

EP 4 660 884 A1

## FIG. 5B

auxiliary device array

**pulse(∝ x)**

$G_{11}$ $G_{21}$ $\cdots$ $G_{M1}$

$G_{12}$ $G_{22}$ $\cdots$ $G_{M2}$

$G_{1N}$ $G_{2N}$ $\cdots$ $G_{MN}$

**pulse(∝ d)**

## FIG. 5C

auxiliary device array

**input**

V

$G_{11}$ $G_{21}$ $\cdots$ $G_{M1}$

0

$G_{12}$ $G_{22}$ $\cdots$ $G_{M2}$

0

$G_{1N}$ $G_{2N}$ $\cdots$ $G_{MN}$

$I_1$ $I_2$ $I_M$

# FIG. 5D

**auxiliary device array**

**perform a reset operation and an invert operations according to random variables**

reset

invert

| | Invert method | | |
|---|---|---|---|
| Update | Potentiation : N1 & N2 on<br>Depression : N3 & N4 on | invert | Potentiation : N1 & N2 on<br>Depression : N3 & N4 on |
| Read | $I_1 - I_2$<br>$I_1$ : only N3 on → N5 read<br>$I_2$ : only N1 on → N6 read | invert | $I_2 - I_1$<br>$I_1$ : only N3 on → N5 read<br>$I_2$ : only N1 on → N6 read |
| Reference read | $I_1 - I_2$<br>$I_1$ : only N1 on → N5 read<br>$I_2$ : only N3 on → N6 read | invert | $I_2 - I_1$<br>$I_1$ : only N1 on → N5 read<br>$I_2$ : only N3 on → N6 read |

*FIG. 5E*

## FIG. 5F

core device array

## FIG. 6

## FIG. 7A

## FIG. 7B

## FIG. 7C

Retention characteristic

| Device | Time constant |
|---|---|
| Si-CMOS+capacitor[17] | Order of seconds |
| Our work (IGZO) | 775 min |

Time constant = 775min

## FIG. 7D

## FIG. 7E

## FIG. 8A

## FIG. 8B

Bit length : 10
Total epochs : 20
Input data per 1 epoch : 25

## FIG. 9A

## FIG. 9B

LENET5

## FIG. 9C

LENET5

## FIG. 10

## FIG. 11A

### LENET5

## FIG. 11B

### MLP

## FIG. 12A

### retension(5e8)

## FIG. 12B

### retension(∞)

# INTERNATIONAL SEARCH REPORT

International application No.

**PCT/KR2024/001021**

| A. | CLASSIFICATION OF SUBJECT MATTER |
|---|---|

**G06N 3/063**(2006.01)i; **G06N 3/08**(2006.01)i; **H01L 27/06**(2006.01)i

According to International Patent Classification (IPC) or to both national classification and IPC

| B. | FIELDS SEARCHED |
|---|---|

Minimum documentation searched (classification system followed by classification symbols)

G06N 3/063(2006.01); G06N 3/04(2006.01); G06N 3/08(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 가중치 캐패시터(weight capacitor), 제어 트랜지스터(control transistor), 드레인 전류(drain current), 강화(potentiation), 약화(depression), 업데이트(update), 순전파(forward propagation), 역전파(back propagation)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2490774 B1 (INDUSTRY-UNIVERSITY COOPERATION FOUNDATION HANYANG UNIVERSITY ERICA CAMPUS et al.) 20 January 2023 (2023-01-20) See paragraphs [0010]-[0018], [0032], [0040]-[0049], [0089]-[0097] and [0102]; claim 10; and figures 1-2 and 9. | 1-14 |
| A | | 15-19 |
| Y | KR 10-2017-0080440 A (SK HYNIX INC.) 10 July 2017 (2017-07-10) See paragraphs [0026]-[0027], [0042] and [0063]-[0069]. | 1-13 |
| Y | KR 10-2022-0084774 A (KWANGWOON UNIVERSITY INDUSTRY-ACADEMIC COLLABORATION FOUNDATION) 21 June 2022 (2022-06-21) See paragraphs [0010]-[0011], [0021] and [0065]. | 9-11,13-14 |
| A | US 2017-0154257 A1 (INTERNATIONAL BUSINESS MACHINES CORPORATION) 01 June 2017 (2017-06-01) See claim 19. | 1-19 |

| ✓ Further documents are listed in the continuation of Box C. | ✓ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **23 April 2024** | **23 April 2024** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
|---|
| **PCT/KR2024/001021** |

**C.     DOCUMENTS CONSIDERED TO BE RELEVANT**

| Category* | Citation of document, with indication, where appropriate, of the relevant passages | Relevant to claim No. |
|---|---|---|
| A | KR 10-2022-0050160 A (MICRON TECHNOLOGY, INC.) 22 April 2022 (2022-04-22)<br>See claims 1 and 2. | 1-19 |

Form PCT/ISA/210 (second sheet) (July 2022)

## INTERNATIONAL SEARCH REPORT
### Information on patent family members

International application No.

**PCT/KR2024/001021**

| Patent document cited in search report | | | Publication date (day/month/year) | Patent family member(s) | | | Publication date (day/month/year) |
|---|---|---|---|---|---|---|---|
| KR | 10-2490774 | B1 | 20 January 2023 | KR | 10-2020-0135148 | A | 02 December 2020 |
| KR | 10-2017-0080440 | A | 10 July 2017 | KR | 10-2519809 | B1 | 11 April 2023 |
| KR | 10-2022-0084774 | A | 21 June 2022 | KR | 10-2533908 | B1 | 18 May 2023 |
| US | 2017-0154257 | A1 | 01 June 2017 | CN | 107851215 | A | 27 March 2018 |
| | | | | CN | 107851215 | B | 03 August 2021 |
| | | | | JP | 2019-505065 | A | 21 February 2019 |
| | | | | JP | 6943847 | B2 | 06 October 2021 |
| | | | | US | 10832127 | B2 | 10 November 2020 |
| | | | | WO | 2017-093848 | A1 | 08 June 2017 |
| KR | 10-2022-0050160 | A | 22 April 2022 | CN | 114270374 | A | 01 April 2022 |
| | | | | EP | 4018389 | A1 | 29 June 2022 |
| | | | | EP | 4018389 | A4 | 11 October 2023 |
| | | | | JP | 2022-544982 | A | 24 October 2022 |
| | | | | US | 10861539 | B1 | 08 December 2020 |
| | | | | US | 11380391 | B2 | 05 July 2022 |
| | | | | US | 2021-0104276 | A1 | 08 April 2021 |
| | | | | WO | 2021-034502 | A1 | 25 February 2021 |

Form PCT/ISA/210 (patent family annex) (July 2022)